# EUROPEAN PATENT APPLICATION

(11) **EP 4 773 437 A1**
(43) Date of publication of application: **08.07.2026**
(21) Application number: 24865826.2
(22) Date of filing: 11.09.2024
(51) Int. Cl.: H01Q 5/307, H01Q 1/24, H04M 1/02, H05K 1/14, G06F 3/041

(54) **ELECTRONIC DEVICE COMPRISING ANTENNA**

(30) Priority: 11.09.2023 KR 20230120327; 07.11.2023 KR 20230152907
(71) Applicant: Samsung Electronics Co., Ltd., Suwon-si, Gyeonggi-do 16677 (KR)
(72) Inventor: KIM, Jaehyung, Suwon-si Gyeonggi-do 16677 (KR); BAE, Hongpyo, Suwon-si Gyeonggi-do 16677 (KR); KIM, Seunghwan, Suwon-si Gyeonggi-do 16677 (KR); KIM, Jongwon, Suwon-si Gyeonggi-do 16677 (KR); KIM, Taegyu, Suwon-si Gyeonggi-do 16677 (KR); MOON, Jesun, Suwon-si Gyeonggi-do 16677 (KR); YUN, Himchan, Suwon-si Gyeonggi-do 16677 (KR); CHUN, Jaebong, Suwon-si Gyeonggi-do 16677 (KR); HWANG, Hochul, Suwon-si Gyeonggi-do 16677 (KR)
(74) Representative: HGF
(86) International application number: PCT/KR2024/013771
(87) International publication number: WO 2025/058387

(57) **Abstract**

An electronic device includes a display, a rear cover, a side member surrounding the space between the display and the rear cover, the side member having a groove formed therein, a side key disposed the groove and including a conductive portion, a wireless communication circuit, at least one processor, and a first conductive connection member electrically connecting the at least one processor to the side key. The wireless communication circuit is configured to feed power to a first portion of the side member surrounding an edge of the groove through the first conductive connection member electrically connecting the at least one processor to the side key, and transmit and/or receive radio frequency (RF) signals in a specified frequency band, based on an electrical path formed in the first portion of the side member and the conductive portion of the side key.

## Description

### [TECHNICAL FIELD]

The disclosure relates to an electronic device including an antenna.

### [BACKGROUND ART]

With the growth of communication technologies, electronic devices can include a plurality of antennas in order to support various radio access technologies (RATs). For example, the electronic devices can include antennas for supporting 5th-generation (5G) communication (or new radio (NR)) as well as long term evolution (LTE).

With the trend of miniaturized and lightweight devices, the electronic devices can use side members of the electronic devices as antenna radiators in order to reduce or minimize a mounting space for the antennas.

### [DISCLOSURE OF INVENTION]

### [SOLUTION TO PROBLEM]

According to an aspect of the disclosure, an electronic device comprises a display; a rear cover; a side member surrounding a space between the display and the rear cover, wherein the side member comprises a groove; a side key disposed in the groove and comprising a conductive portion; a wireless communication circuit; at least one processor; and a first conductive connection member electrically connecting the at least one processor to the side key, wherein the wireless communication circuit is configured to: feed power to a first portion of the side member surrounding an edge of the groove through the first conductive connection member electrically connecting the at least one processor to the side key; and transmit and/or receive radio frequency (RF) signals in a specific frequency band, based on an electrical path formed in the first portion and the conductive portion.

The electronic device further comprises: a first protrusion extending from a portion of the side member adjacent to a first end of the groove, wherein the first protrusion extends in a direction from the first end toward a second end of the groove; and a second conductive connection member disposed between the first protrusion and the first conductive connection member, wherein the wireless communication circuit is further configured to feed power to the first portion through the first conductive connection member, the second conductive connection member, and the first protrusion, and wherein the second conductive connection member comprises at least one of a C-clip or a conductive gasket.

The electronic device further comprises: a second protrusion extending from a portion of the side member adjacent to the second end of the groove, wherein the second protrusion extends in a direction from the second end toward the first end; a third conductive connection member disposed between the second protrusion and the first conductive connection member; and a switch circuit electrically connected to the second protrusion through the first conductive connection member and the third conductive connection member, wherein the third conductive connection member comprises at least one of a C-clip or a conductive gasket.

The electronic device further comprises: a printed circuit board comprising the wireless communication circuit and a ground, wherein the switch circuit is electrically connected to the ground and comprises at least one lumped element, and wherein the switch circuit is configured to adjust the specific frequency band by changing a length of the electrical path using the at least one lumped element.

The wireless communication circuit is further configured to transmit a control signal for controlling the switch circuit through the first conductive connection member.

The first conductive connection member comprises: a first conductive path for feeding power to the first portion; a second conductive path for transmitting a signal from the side key; and a region in which the first conductive path is exposed, and the first conductive path is connected to the second conductive connection member in the region.

The side key further comprises a non-conductive portion disposed along an edge of the conductive portion, and the non-conductive portion is disposed between the conductive portion of the side key and the first portion of the side member.

The electronic device further comprises a support member comprising a conductive material, wherein the support member contacts a rear face of the side key, and fixes the side key into the groove.

The side member comprises a conductive material and forms at least a portion of a side face of the electronic device in a seamless loop shape, and the first portion and the side key form a portion of the side face of the electronic device without steps.

The electronic device comprises a printed circuit board on which the wireless communication circuit and the at least one processor are disposed, the first conductive connection member comprises a first portion connected to a connector of the printed circuit board, and a second portion forming a rear face of the side key, and the at least one processor is configured to transmit a control signal to the side key through the first conductive connection member, or to receive a signal from the side key through the first conductive connection member.

The electrical path is formed at an edge of the first portion and an edge of the conductive portion, and the edge of the first portion is spaced apart from and electromagnetically connected to the edge of the conductive portion.

The electronic device further comprises a non-conductive member formed on an inner surface of the side member, the non-conductive member comprises an opening at least partially overlapping the groove, and the opening is for the side key to be entered in the groove.

The opening comprises a first region overlapping the groove and a second region extending from the first region and overlapping the side member, and the second conductive connection member is electrically connected to the side member through the second region.

The first conductive connection member comprises at least one of a flexible printed circuit board (FPCB), a printed circuit board, a portion of a touch panel comprised in the side key, or a flexible RF cable (FRC).

The side key comprises a touch panel, and the side key is configured to identify a touch input of a user to the touch panel based on a pressure applied to the touch panel, and transmit, to the at least one processor, a signal indicating identification of touch input of the user.

According to an aspect of the disclosure, an electronic device comprises a side member comprising a groove, wherein the side member forms a side face of the electronic device; a side key disposed in the groove, wherein the side key comprises a conductive portion; a wireless communication circuit; at least one processor; and a first conductive connection member electrically connecting the at least one processor to the side key, wherein the wireless communication circuit is configured to: feed power to a first portion of the side member surrounding an edge of the groove through the first conductive connection member, and transmit and/or receive radio frequency (RF) signals in a specific frequency band, based on an electrical path that is formed in the first portion and the conductive portion.

### [BRIEF DESCRIPTION OF DRAWINGS]

The above and other aspects, features, and advantages of certain embodiments of the present disclosure will be more apparent from the following description taken in conjunction with the accompanying drawings, in which:
FIG. 1 is a diagram illustrating an electronic device in a network environment, according to an embodiment;
FIG. 2A is a perspective view of an electronic device according to an embodiment;
FIG. 2B is a perspective view illustrating the electronic device of FIG. 2A seen from the rear;
FIG. 2C is a diagram illustrating a side member and a side key of an electronic device, according to an embodiment;
FIG. 2D is an exploded view of an electronic device according to an embodiment;
FIG. 3A is a diagram illustrating a wireless communication circuit and a processor that are connected to a side key disposed in a groove, according to an embodiment;
FIG. 3B is a diagram illustrating a side key disposed in a groove, according to an embodiment;
FIG. 4A is a diagram illustrating a side key that is entered in a groove from the outside of an electronic device, according to an embodiment;
FIG. 4B is a diagram illustrating a wireless communication circuit that feeds power to a first side portion when a side key is entered in a groove, according to an embodiment;
FIG. 5 is a diagram illustrating an electrical path that is formed in a side member and a conductive portion of a side key as a wireless communication circuit feeds power to the side member, according to an embodiment;
FIG. 6 is a cross-sectional view taken along line A-A' of a first portion of FIG. 5, according to an embodiment;
FIG. 7 illustrates a current distribution that is formed along an edge of a groove and an edge of a side key when a wireless communication circuit feeds power to a side member including the groove, according to an embodiment;
FIG. 8 is a graph of radiation efficiency when a wireless communication circuit feeds power to a side member including a groove, according to an embodiment;
FIG. 9A is a diagram illustrating a side key that is coupled with a groove in a direction from the inside of an electronic device to the outside of the electronic device, according to an embodiment;
FIG. 9B is a diagram illustrating a fixing member for fixing a groove when a side key is coupled with the groove within an electronic device, according to an embodiment;
FIG. 10A is a cross-sectional view taken along line B-B' of a side member of FIG. 9B, according to an embodiment;
FIG. 10B is a diagram illustrating before and after a side key is entered in a groove shown in FIG. 10A, according to an embodiment;
FIG. 10C is a diagram illustrating a process in which a side key is entered in a groove when a fixing member is formed within a first side portion, according to an embodiment;
FIG. 11 illustrates a current distribution that is formed along an edge of a groove and an edge of a side key when a wireless communication circuit of FIG. 10A feeds power to a side member including the groove, according to an embodiment;
FIG. 12 is a graph of radiation efficiency when a wireless communication circuit of FIG. 10A feeds power to a side member including a groove, according to an embodiment;
FIG. 13 is a diagram illustrating an electronic device including a second protrusion, according to an embodiment;
FIG. 14 is a diagram illustrating a side key including a plurality of fill-cut regions and a side member including a plurality of protrusions, according to an embodiment;
FIG. 15 is a cross-sectional view taken along line C-C' of the side member of FIG. 14, according to an embodiment;
FIG. 16 is a graph of radiation efficiency of an antenna including a groove and a side key dependent on a lumped element connected to a third conductive path, according to an embodiment;
FIG. 17 is a diagram illustrating a C-clip that connects a side member to a wireless communication circuit, according to an embodiment;
FIG. 18 is a diagram illustrating a support member that supports a side key and includes a conductive material, according to an embodiment;
FIG. 19 is a diagram illustrating a side key that is entered in a hole of a support member including a conductive material, according to an embodiment;
FIG. 20 is a cross-sectional view taken along line D-D' of a first side portion of FIG. 19;
FIG. 21 is a diagram comparing before and after a side key is entered in a groove;
FIG. 22 is a diagram illustrating a wireless communication circuit that feeds power to a conductive portion of a side key through a connection member rather than a first conductive connection member, according to an embodiment; and
FIG. 23 is a diagram illustrating a first connection member including a first fill-cut region and a second connection member including a second fill-cut region, according to an embodiment.

In relation to the description of the drawings, identical or similar reference numerals may be used for identical or similar components.

### [MODE FOR THE INVENTION]

Various embodiments of the disclosure are described below with reference to the accompanying drawings. However, this following description is not intended to limit the disclosure to specific embodiment forms, and should be understood as including various modifications, equivalents, and/or alternatives to the embodiments of the disclosure.

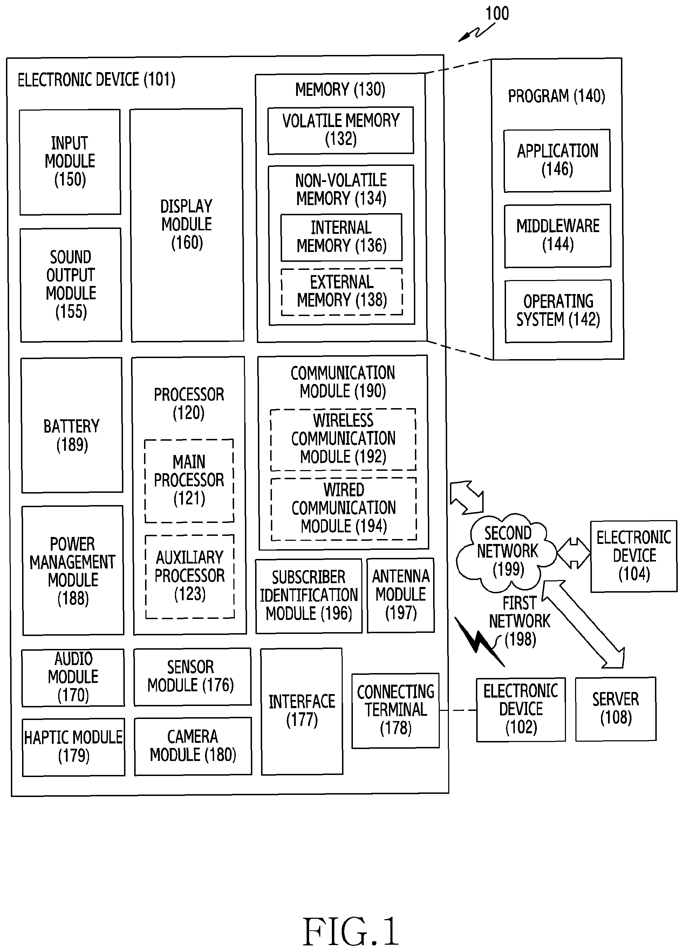

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In one or more embodiments, at least one of the components (e.g., the connecting terminal 178) may be omitted from the electronic device 101, or one or more other components may be added in the electronic device 101. In one or more embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197. According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of, the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

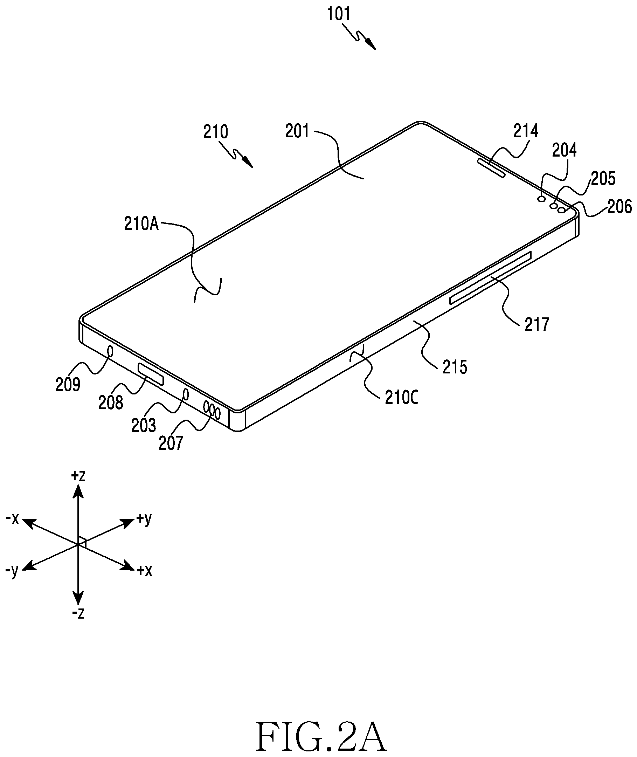

FIG. 2A is a perspective view of an electronic device according to an embodiment.

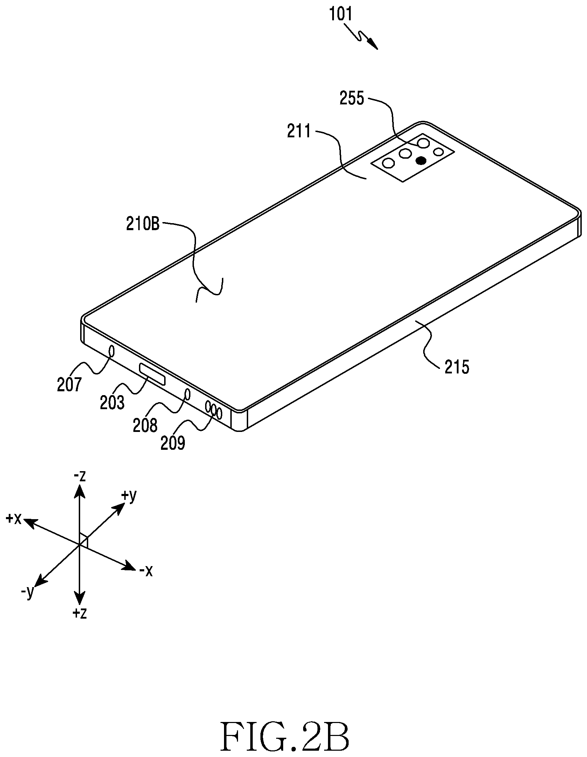

FIG. 2B is a perspective view illustrating the electronic device of FIG. 2A seen from the rear.

Referring to FIGS. 2A and 2B, the electronic device 101 of an embodiment may include a housing 210 that includes a first face (or front face) 210A, a second face (or rear face) 210B, and a side face (or side wall) 210C surrounding the space between the first face 210A and the second face 210B. As another example, the housing 210 may be referred to as a structure forming at least a portion of the first face 210A, second face 210B, or side face 210C of FIGS. 2A and 2B.

According to an embodiment, the first face 210A of the electronic device 101 may be formed at least in part by a display 201.

In FIGS. 2A and 2B of the disclosure, the display 201 is described as forming the front face of the electronic device 101 without a front plate, but this is only an example. For example, the first face 210A of the electronic device 101 may be formed at least in part by a substantially transparent front plate (e.g., a glass plate including various coating layers, or a polymer plate).

According to an embodiment, the second face 210B may be formed by a substantially opaque rear cover 211. For example, the rear cover 211 may be made of coated or colored glass, ceramic, polymer, metal (e.g., aluminum (Al), stainless steel (STS), or magnesium (Mg)), or a combination of at least two of the foregoing materials.

According to an embodiment, the side face 210C of the electronic device 101 may be coupled with the display 201 and the rear cover 211, and may be formed by a side member 215 including metal and/or polymer. For another example, the rear cover 211 and the side member 215 may be formed integrally, and may include substantially the same material (e.g., a metal material such as aluminum (Al)).

According to an embodiment, the electronic device 101 may include at least one or more of the display 201, the audio module 170, a sensor module 204, a first camera module 205 and 206, a key input device 217 (also referred to herein as side key 217), a first connector hole 208, and a second connector hole 209. For another example, the electronic device 101 may omit at least one of the components or may additionally include other components.

According to an embodiment, the display 201 may be coupled with or be disposed adjacent to a touch detection circuit, a pressure sensor capable of measuring the intensity (pressure) of touch, and/or a digitizer detecting a magnetic field-type stylus pen.

According to an embodiment, an audio module (e.g., the audio module 170 of FIG. 1) may output sound, or receive sound, through a microphone hole 203, at least one speaker hole 207, and a call receiver hole 214. For example, a microphone of the audio module 170 for acquiring external sound may be disposed inside the microphone hole 203. For example, a plurality of microphones may be disposed inside the microphone hole 203 and detect the direction of sound.

For another example, the at least one speaker hole 207 and the call receiver hole 214 may be implemented as a single hole along with the microphone hole 203, or a speaker may be included without the at least one speaker hole 207 and the call receiver hole 214 (e.g., a piezo speaker).

In an embodiment, the electronic device 101 may include the sensor module 204, and may generate an electrical signal or data value corresponding to an internal operating state or external environmental state of the electronic device 101. For example, the sensor module 204 may further include a proximity sensor disposed in the first face 210A of the housing 210, a fingerprint sensor integrated with or disposed adjacent to the display 201, and/or a biometric sensor (e.g., a heart rate monitor (HRM) sensor) disposed in the second face 210B of the housing 210. For example, the electronic device 101 may further include a non-shown sensor module (e.g., a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, and/or an illumination sensor.

The sensor module 204 of the disclosure may correspond to the sensor module 176 of FIG. 1. For example, a description of the sensor module 176 may be applied to the sensor module 204.

According to an embodiment, the electronic device 101 may include a second camera module 255 disposed in the second face 210B. The first camera module 205 and 206 and the second camera module 255 may include one or more lenses, an image sensor, and/or an image signal processor. A flash may be disposed in the second face 210B. For example, the flash may include a light emitting diode or a xenon lamp. For another example, two or more lenses (infrared camera, and wide-angle and telephoto lens) and image sensors may be disposed on one face of the electronic device 101.

According to an embodiment, the side key 217 may be disposed in the side face 210C of the housing 210. For example, the side key 217 may include at least one of a fingerprint sensor or a touch panel.

According to an embodiment, the connector holes 208 and 209 may include the first connector hole 208 capable of accommodating a connector (e.g., a USB connector) for transmitting and receiving power and/or data with an external electronic device, and/ the second connector hole (e.g., an earphone jack) 209 capable of accommodating a connector for transmitting and receiving an audio signal with the external electronic device.

In FIGS. 2A and 2B, the electronic device 101 has been illustrated as corresponding to a bar type, but this is only an example and the electronic device 101 may actually correspond to various types of devices. For example, the electronic device 101 may correspond to a foldable device, a slidable device, a wearable device (e.g., a smart watch, and a wireless earphone), or a tablet PC. Therefore, the technical idea disclosed in the disclosure is not limited to the bar type device illustrated in FIGS. 2A and 2B and may be applied to various types of devices.

FIGS. 2A and 2B illustrate the display 201 not folded, but this is only an example. For example, the display 201 may include a flexible display that is folded or unfolded about a first axis (e.g., an x-axis).

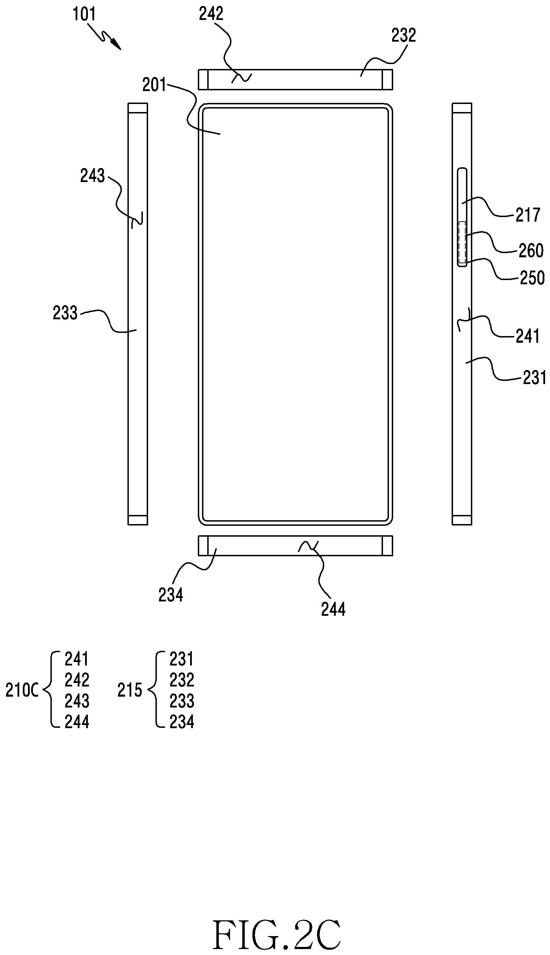

FIG. 2C is a diagram illustrating a side member and a side key of an electronic device, according to an embodiment.

Referring to FIG. 2C, the electronic device 101 of an embodiment may include the side member 215 that forms at least a portion of the side face 210C. The side member 215 may include a first side portion 231, a second side portion 232, a third side portion 233, and/or a fourth side portion 234.

According to an embodiment, the side member 215 may form at least a portion of the side face 210C of the electronic device 101. For example, the first side portion 231 may form at least a portion of a first side face 241 of the electronic device 101. The second side portion 232 may form at least a portion of a second side face 242 of the electronic device 101. The third side portion 233 may form at least a portion of a third side face 243 of the electronic device 101. The fourth side portion 234 may form at least a portion of a fourth side face 244 of the electronic device 101.

In FIG. 2C of the disclosure, for convenience of explanation, it has been described that the side portions (e.g., the first side portion 231) included in the side member 215 form the side face 210C of the electronic device 101, but this is only an example. For example, the side member 215 may be expressed as forming the side face 210C of the electronic device 101 without defining the side portions. For example, the side member 215 may form the first side face 241 of the electronic device 101.

According to an embodiment, the side member 215 may include a conductive material. For example, the side member 215 may be formed of a conductive material (e.g., aluminum).

According to an embodiment, the side member 215 may have a seamless loop shape. For example, the side member 215 may form the side face 210C in the seamless loop shape. For example, the side member 215 may be formed in the loop shape without a segment portion including a non-conductive material (e.g., an injection member). For example, the first side portion 231 may be connected to the second side portion 232 and the fourth side portion 234, and the fourth side portion 234 may be connected to the first side portion 231 and the third side portion 233. As a result, the side member 215 may have the seamless loop shape.

For another example, the side member 215 may have a continuous loop shape.

According to an embodiment, the first side portion 231 may be substantially parallel to the third side portion 233, and the second side portion 232 may be substantially parallel to the fourth side portion 234. At least a portion of the first side portion 231 may be substantially perpendicular to the second side portion 232 and the fourth side portion 234. At least a portion of the third side portion 233 may be substantially perpendicular to the second side portion 232 and the fourth side portion 234.

According to an embodiment, the side key 217 may include a component or device that identifies a contact location and/or information indicating a contact when a user or an object (e.g., a pen) contacts the side key 217. For example, the side key 217 may identify that the user's body (e.g., a finger) contacts the side key 217 or is located within a specified distance from the side key 217, and may transmit a signal or information indicating that a user input (e.g., a touch input) has been identified to the processor 120.

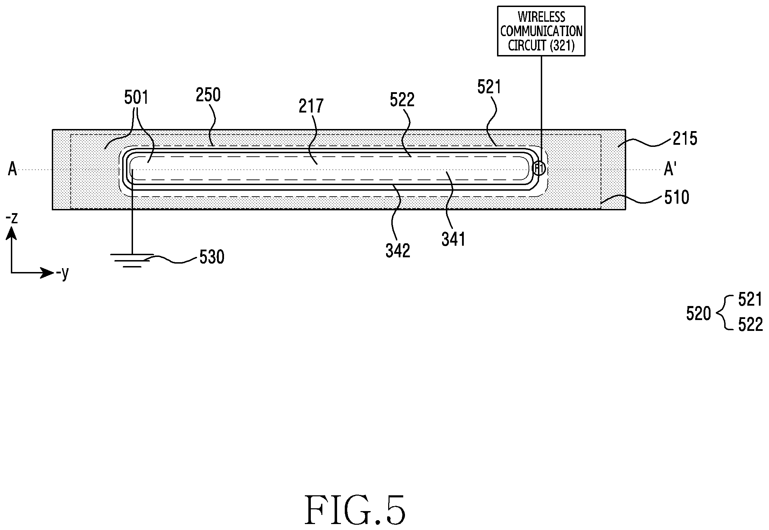

According to an embodiment, the signal indicating that the user input has been identified may include a trigger or event that allows the electronic device 101 to select an antenna other than an antenna including a groove 250 between a conductive portion of the side key 217 and the side member 215 and perform wireless communication. For example, as described below, the electronic device 101 may implement an antenna (e.g., an antenna 501 of FIG. 5) that uses a potential difference between the side member 215 in which the groove 250 is formed and the conductive portion of the side key 217. For example, when a user brings a part (e.g., a finger) of the body close to the side key 217 while the electronic device 101 is performing wireless communication in a specified frequency band through the antenna, the electronic device 101 may identify from the side key 217 the signal indicating that the user input has been identified. In this case, the electronic device 101 may perform wireless communication in a specified frequency band by using other antennas within the electronic device 101 instead of an antenna that uses the side member 215 in which the groove 250 is formed and the side key 217.

According to an embodiment, the side key 217 may be implemented in various methods. For example, the side key 217 may include a resistive touch panel that uses transparent electrode layers. For example, the side key 217 may include a capacitive touch panel that identifies a user input (e.g., a touch input) by using a potential difference. According to an embodiment, the side key 217 may form at least a portion of the first side face 241 together with the first side portion 231 of the side member 215. For example, the side key 217 may be disposed in the groove 250 formed in the first side portion 231. The side key 217 disposed in the groove 250 may form the first side face 241 together with the first side portion 231.

In FIG. 2C of the disclosure, it has been described that the side key 217 corresponds to a key button, but this is only an example. For example, the side key 217 may include a key button 260 that operates based on physical pressure. In this case, when a user applies pressure to the side key 217 by using a part (e.g., a finger) of the body, the side key 217 may identify whether a user input has been input, based on the presence or absence of the physical pressure as well as the potential difference of the side key 217.

For another example, the side key 217 itself may perform a key button function that operates based on physical pressure. For example, when a user applies pressure to the side key 217 by using a part (e.g., a finger) of the body, the side key 217 may identify a user input to the side key 217, based on the pressure as well as the potential difference.

According to an embodiment, the side key 217 may include a touch panel, and the side key 217 may be configured to identify a user's touch input to the touch panel or identify a pressure applied to the touch panel, and transmit, to the processor 120, a signal that indicates the presence of the user's input, based on the touch input or the pressure.

The term "groove" of the disclosure may be replaced with the terms slit, hole, opening portion, opening, slot or pit.

The term "side key" of the disclosure may be replaced with the terms touch panel, touch screen, touch display, or touch screen panel (TSP).

The term "side member" of the disclosure may be replaced with the terms "frame forming a side face", "housing portion forming a side face", or "conductive side member".

The term "side portion" of the disclosure may be replaced with the terms side member, portion, part, or conductive portion. For example, the first side portion 231 may be replaced with terms first side member, first portion, first part, first frame, or first conductive portion.

The electronic device 101 of the disclosure has been described as not including a segment portion or non-conductive material that physically separates the side member 215, but this is only an example. For example, the electronic device 101 may include at least one segment portion or non-conductive material, and the side member 215 may be divided into side portions through the at least one segment portion or non-conductive material. For example, a first segment portion including a non-conductive material may be disposed between the first side portion 231 and the second side portion 232, and a second segment portion including a non-conductive material may be disposed between the second side portion 232 and the third side portion 233.

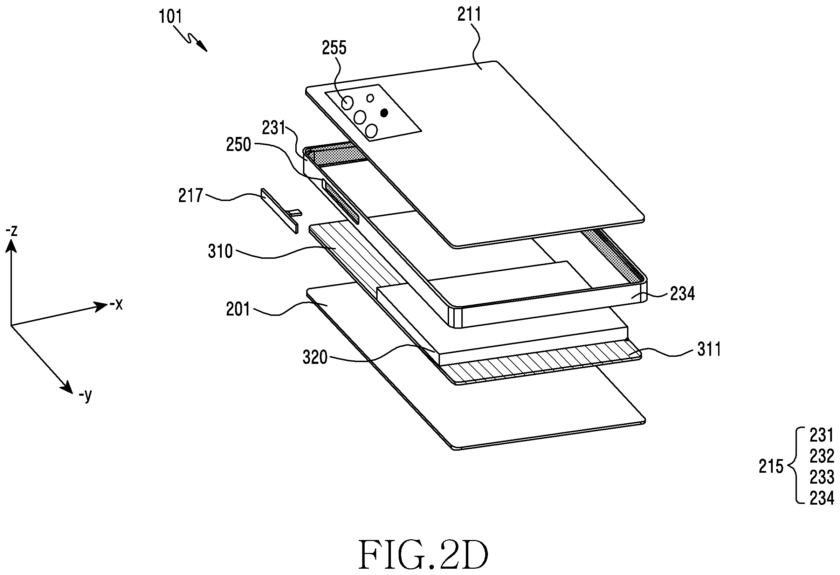

FIG. 2D is an exploded view of an electronic device according to an embodiment.

Referring to FIG. 2D, the electronic device 101 of an embodiment may include the rear cover 211, the side member 215, the side key 217, a first printed circuit board 310, a second printed circuit board 311, a battery 320, and/or the display 201.

According to an embodiment, the side member 215 may surround the space between the display 201 and the rear cover 211. For example, the side member 215 may be coupled with the display 201 and the rear cover 211, thereby forming or defining the inner space of the electronic device 101.

According to an embodiment, various electronic components may be disposed in the inner space of the electronic device 101 formed or defined by the side member 215, the display 201, and the rear cover 211. For example, the first printed circuit board 310, the second printed circuit board 311, and/or the battery 320 may be disposed in the inner space of the electronic device 101.

According to an embodiment, the battery 320 may provide power to at least some of the electronic components included in the electronic device 101. For example, the battery 320 may supply power for a wireless communication circuit (e.g., a radio frequency integrated circuit (RFIC)) described below.

The battery 320 of the disclosure may correspond to the battery 189 of FIG. 1 and accordingly, the description of the battery 189 of FIG. 1 may be applied to the battery 320.

According to an embodiment, the first printed circuit board 310 and the second printed circuit board 311 may be disposed in different locations based on the battery 320. For example, the first printed circuit board 310 may be disposed in an upward direction (e.g., +y direction) based on the battery 320. The second printed circuit board 311 may be disposed in a downward direction (e.g., -y direction) opposite to the upward direction based on the battery 320.

For another example, the first printed circuit board 310 may be disposed at an upper end portion of the electronic device 101. The second printed circuit board 311 may be disposed at a lower end portion of the electronic device 101. The upper end portion may be referred to as a part of the electronic device 101 located in the upward direction (e.g., +y direction) based on the battery 320. The lower end portion may be referred to as a part of the electronic device 101 located in the downward direction (e.g., -y direction) based on the battery 320.

According to an embodiment, the first printed circuit board 310 may be physically separated from, but electrically connected to, the second printed circuit board 311. For example, the first printed circuit board 310 may be electrically connected to the second printed circuit board 311 through a conductive member (e.g., a flexible printed circuit board (FPCB)).

According to an embodiment, the first printed circuit board 310 and the second printed circuit board 311 may provide an electrical connection path for various components in the electronic device 101, or provide a space for arranging various components. For example, the processor 120 may be disposed on the first printed circuit board 310, and the first printed circuit board 310 may provide a conductive path electrically connecting the side key 217 to the processor 120. For example, the power management module 188 may be disposed on the first printed circuit board 310, and the first printed circuit board 310 may provide a conductive path electrically connecting the power management module 188 to the battery 320.

The processor 120 of the disclosure may include at least one processor as described in FIG. 1. For example, the processor 120 may include an application processor (AP) and a communication processor (CP). For another example, processor 120 may include only the AP.

In FIG. 2D of the disclosure, it has been described that the first printed circuit board 310 and the second printed circuit board 311 are disposed in different locations based on the battery 320, but this is only an example. For example, the first printed circuit board 310 may be stacked on the second printed circuit board 311. In this case, the first printed circuit board 310 may be electrically connected to the second printed circuit board 311 through an interposer.

In FIG. 2D of the disclosure, it has been described that the first printed circuit board 310 and the second printed circuit board 311 are separate components, but this is only an example. For example, the first printed circuit board 310 and the second printed circuit board 311 may be formed as one printed circuit board. In this case, the battery 320 may be located or disposed in a -z direction or +z direction of one printed circuit board.

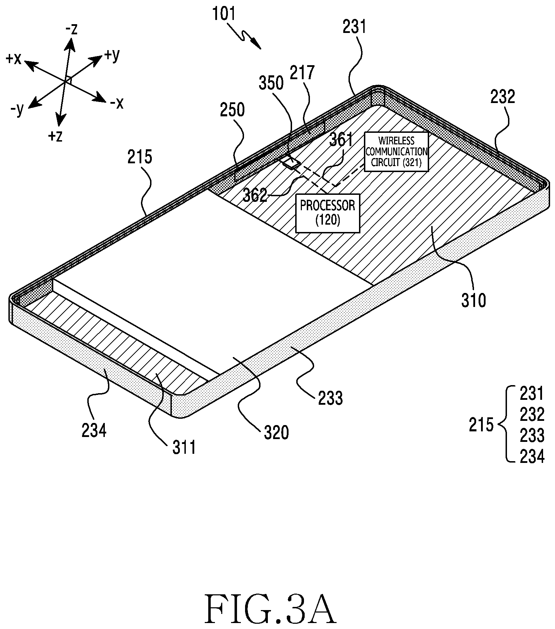

FIG. 3A is a diagram illustrating a wireless communication circuit and a processor that are connected to a side key disposed in a groove, according to an embodiment.

Referring to FIG. 3A, the electronic device 101 of an embodiment may include the groove 250, the side key 217, the first printed circuit board 310, a wireless communication circuit 321, and/or the processor 120.

According to an embodiment, the groove 250 may be formed in the side member 215. For example, the groove 250 may be formed in the first side portion 231 of the side member 215.

According to an embodiment, the groove 250 may have various shapes. For example, the groove 250 formed in the side member 215 may be formed lengthwise in a third direction (e.g., +y direction). For another example, the groove 250 may have a rectangular shape, an elliptical shape, or a polygonal shape. For example, the groove 250 may have a shape corresponding to the side key 217.

According to an embodiment, the processor 120 may be disposed on or in the first printed circuit board 310. For example, the processor 120 may include an AP, and the AP may be disposed on the first printed circuit board 310. For another example, the processor 120 may include an AP and a CP, and the AP and the CP may be disposed on the first printed circuit board 310.

However, in FIG. 3A, it has been described that the processor 120 is disposed on the first printed circuit board 310, but this is only an example, and the disclosure is not limited thereto. For example, the AP of the processor 120 may be disposed in the first printed circuit board 310, and the CP may be disposed in the second printed circuit board 311.

According to an embodiment, the wireless communication circuit 321 may be disposed on or in the first printed circuit board 310.

According to an embodiment, the wireless communication circuit 321 may include an intermediate frequency integrated circuit (IFIC) and/or an RFIC. For example, the wireless communication circuit 321 may process RF signals in an FR1 frequency band (e.g., 7.125 GHz) or less, and in this case, the wireless communication circuit 321 may include only the RFIC. In an example, the RFIC of the wireless communication circuit 321 may convert baseband (BB) signals received from the CP of the processor 120 into RF signals and transmit the RF signals to an antenna radiator (e.g., the side member 215).

For another example, the wireless communication circuit 321 may process RF signals in an FR2 frequency band (e.g., 24.25 GHz) or more, and in this case, the wireless communication circuit 321 may include an IFIC and an RFIC. In an example, the IFIC of the wireless communication circuit 321 may convert BB signals received from the CP of the processor 120 into IF signals and transmit the IF signals to the RFIC, and the RFIC of the wireless communication circuit 321 may convert IF signals into RF signals and transmit the RF signals to the antenna radiator.

According to an embodiment, the side key 217 may include a first conductive connection member 350. For example, the first conductive connection member 350 may include a component in which wires for transmitting signals for the side key 217 are formed or disposed. In an example, the signal for the side key 217 may include an input signal that the side key 217 transmits to the processor 120, based on a user input, and/or a control signal that the processor 120 transmits to the side key 217 in order to control the side key 217.

According to an embodiment, the wires included in the first conductive connection member 350 may be used as a feeding line for feeding power to the side member 215 in which the groove 250 is formed.

According to an embodiment, the wireless communication circuit 321 may be electrically connected to the first conductive connection member 350 of the side key 217 disposed in the groove 250. For example, the side key 217 may include the first conductive connection member 350, and a first conductive line 361 electrically connecting the wireless communication circuit 321 to the first conductive connection member 350 may be formed in the first printed circuit board 310. For example, the first conductive line 361 may include a conductive connection line, a conductive via, and/or an interposer that are formed in a plurality of layers of the first printed circuit board 310.

According to an embodiment, as the wireless communication circuit 321 is electrically connected to the first conductive connection member 350 through the first conductive line 361, the wireless communication circuit 321 may feed power to the side member 215 via the first conductive connection member 350. For example, the wireless communication circuit 321 may transmit RF signals in a specified frequency band (e.g., about 3 GHz to about 6 GHz) to the side member 215 via the first conductive connection member 350.

According to an embodiment, the processor 120 may be electrically connected to the side key 217 disposed the groove 250. For example, the side key 217 may include the first conductive connection member 350, and a second conductive line 362 electrically connecting the processor 120 to the first conductive connection member 350 may be formed in the first printed circuit board 310.

According to an embodiment, as the processor 120 is electrically connected to the side key 217 through the first conductive connection member 350, the processor 120 may transmit control signals for controlling the side key 217 to the side key 217, and may receive input signals from the side key 217. In an example, the input signals may be referred to as signals that indicate the presence of a user input, based on the user input (e.g., touch input) to the side key 217.

In FIG. 3A of the disclosure, it has been described that the first conductive connection member 350 is included in the side key 217, but this is only an example. For example, the first conductive connection member 350 may not be formed integrally with the side key 217, and may be also described as a separate component that may be coupled with the side key 217.

In the disclosure, an electrical connection relationship between the wireless communication circuit 321 and the processor 120 has not been illustrated, but the wireless communication circuit 321 may be electrically connected to the processor 120. For example, the processor 120 may include a CP, and the CP may be electrically connected to the wireless communication circuit 321. The wireless communication circuit 321 may receive baseband (BB) signals from the CP and up convert the BB signals into RF signals. In this case, the wireless communication circuit 321 may directly convert the BB signals into the RF signals according to a frequency band supported, or may convert the BB signals into IF signals and then convert the IF signals into the RF signals.

In FIG. 3A of the disclosure, it has been described that the groove 250 is formed in the first side portion 231 of the side member 215, but this is only an example. For example, the groove 250 may be formed in the second side portion 232, the third side portion 233, and/or the fourth side portion 234 of the side member 215.

In FIG. 3A of the disclosure, it has been described that the side key 217 is disposed in the groove 250, but this may be replaced with various expressions. For example, the side key 217 may be expressed as being entered in the groove 250. For example, the side key 217 may be expressed as being coupled with the groove 250. For example, the side key 217 may be expressed as being fixed to the groove 250. For example, the side key 217 may be expressed as being fastened to the groove 250. For example, the side key 217 may be expressed as being adhered to the groove 250.

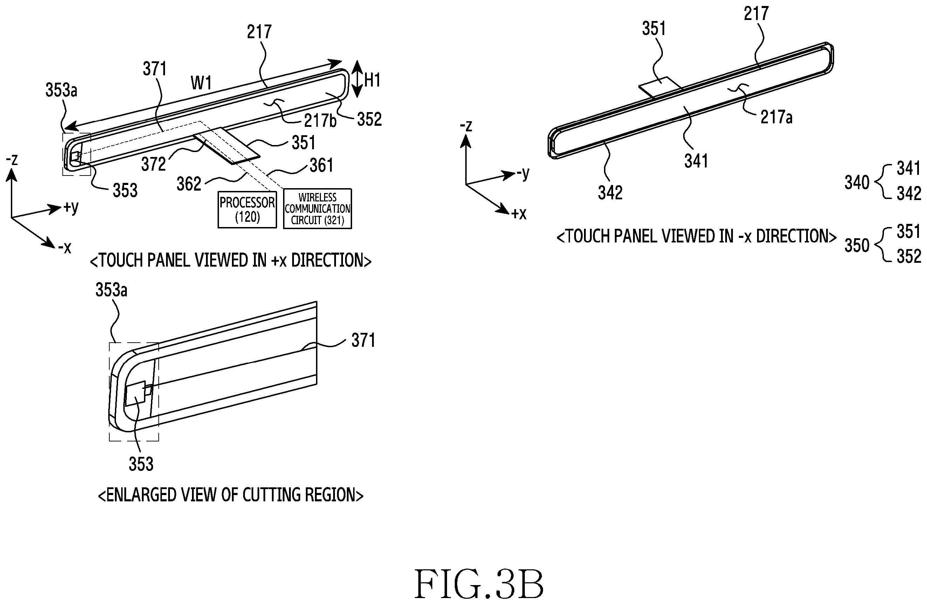

FIG. 3B is a diagram illustrating a side key disposed in a groove, according to an embodiment.

Referring to FIG. 3B, the side key 217 of an embodiment may have a width and height corresponding to the width and height of the groove 250. For example, since the side key 217 must be disposed in the groove 250, the side key 217 may have a first width W1 that is less than or equal to the width of the groove 250. The side key 217 may have a first height H1 that is less than or equal to the height of the groove 250.

According to an embodiment, the side key 217 may include the first conductive connection member 350. For example, the first conductive connection member 350 may include a flexible printed circuit board (FPCB) or a flexible RF circuit (FRC).

According to an embodiment, the first conductive connection member 350 may include a first conductive path 371 for RF signals transmitted from the wireless communication circuit 321 to the side member 215. For example, the first conductive connection member 350 may include the first conductive path 371 for feeding power.

According to an embodiment, the first conductive connection member 350 may include a second conductive path 372 for a control signal transmitted from the processor 120 to the side key 217 and for example, the conductive connection member 350 may include the second conductive path 372 for transmitting and/or receiving a control signal.

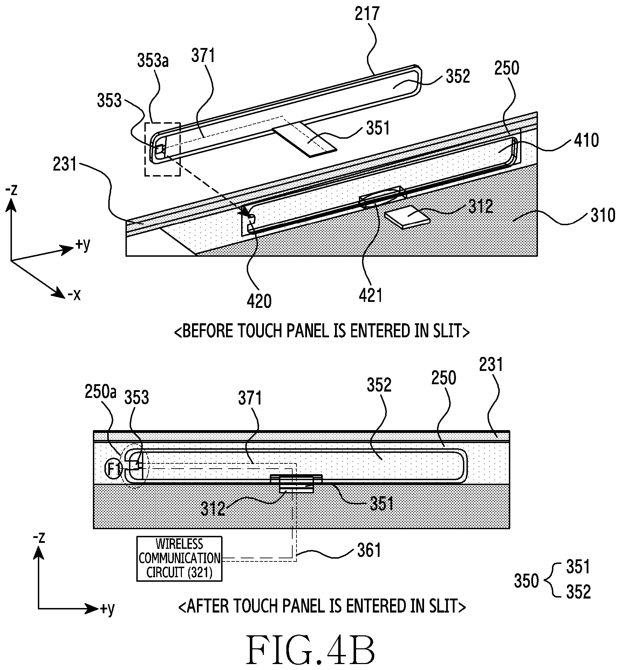

According to an embodiment, the first conductive connection member 350 may include a first connection portion 351 and a second connection portion 352. For example, the second connection portion 352 may include a portion located in a rear face 217b of the side key 217. For example, the first connection portion 351 may include a portion extending from the second connection portion 352 and connected to the first printed circuit board 310. For example, a first end of the first connection portion 351 may be connected to a connector (e.g., a connector 312 of FIG. 4B) of the first printed circuit board 310, and a second end of the first connection portion 351 may be connected to the second connection portion 352.

For another example, the second connection portion 352 of the first conductive connection member 350 may include a portion extending lengthwise in a third direction (e.g., +y direction). The first connection portion 351 may include a portion extending from the second connection portion 352 in a first direction (e.g., -x direction). In an example, the first direction (e.g., -x direction) may be perpendicular to the third direction (e.g., +y direction).

In FIG. 3B of the disclosure, the first conductive connection member 350 has been described as a separate component included in the side key 217, but this is only an example. For example, the first conductive connection member 350 may be described as a part of the side key 217.

In the disclosure, a front face 217a of the side key 217 may include a face facing the outside of the electronic device 101, and the rear face 217b of the side key 217 may include a face facing the inside of the electronic device 101. However, this is a definition for convenience of explanation, and the disclosure is not limited thereto. For example, the front face 217a may be defined as a first face, and the rear face 217b may be defined as a second face opposite to the first face.

According to an embodiment, the side key 217 may include a first fill-cut region 353a (or non-grounded region or non-conductive region) where the first conductive path 371 (or first feeding line or transmission line) is exposed. For example, the second connection portion 352 of the first conductive connection member 350 may include the first fill-cut region 353a where the first conductive path 371 is exposed. In an example, the first fill-cut region 353a includes the non-conductive region and may include a partial layer of the first conductive connection member 350 formed of a non-conductive material for the sake of feeding power.

For example, when the first conductive connection member 350 is a printed circuit board (PCB), the fill-cut region 353a may include a first layer (or upper layer) to a specified layer (e.g., a fifth layer). A wire layer including transmission lines may include a layer (e.g., a sixth layer) below the specified layer to a lower layer.

For example, a portion of a conductive layer forming the surface of the first conductive connection member 350 (e.g., an FPCB) may be removed to expose a non-conductive material, and the first conductive path 371 may be disposed on the non-conductive material, thereby electrically connecting the first conductive path 371 of the first conductive connection member 350 to the side member 215. For example, the first conductive connection member 350 (e.g., a portion of an FPCB, a PCB, or a display) may include the first fill-cut region 353a where the first conductive path 371 for feeding power is disposed on the non-conductive material. As the first conductive path 371 is exposed in the first fill-cut region 353a, the first conductive path 371 may be electrically connected to a second conductive connection member 353.

However, in the disclosure, for convenience of explanation, it has been described that a portion of the conductive layer forming the surface of the first conductive path 371 is removed for electrical connection of the first conductive path 371, but this is only an example, and the disclosure is not limited thereto. For example, for the sake of the electrical connection of the first conductive path 371, a portion of a non-conductive layer located on the surface of the first conductive connection member 350 may be removed. For example, the first conductive path 371 may be formed and exposed to the surface of the first conductive connection member 350, without removing the non-conductive layer for the sake of the electrical connection of the first conductive path 371. For example, when the first conductive connection member 350 is a PCB, the first conductive path 371 is not directly exposed to the surface of the first conductive connection member 350, but may be electrically connected to the side member 215 through a conductive via formed in the PCB.

According to an embodiment, the first conductive connection member 350 including the ground (e.g., the conductive portion 341) may be electrically connected to the ground included in the first printed circuit board 310 and/or the second printed circuit board 311, or may be electrically connected to the ground included within the electronic device 101.

According to an embodiment, the electronic device 101 may include the second conductive connection member 353, and the first conductive path 371 may be electrically connected to the second conductive connection member 353 in the first fill-cut region 353a. For example, the second conductive connection member 353 may be disposed in the first fill-cut region 353a. The first conductive path 371 may contact the second conductive connection member 353 in the first fill-cut region 353a and be electrically connected to the second conductive connection member 353. For example, the first conductive line 361 and the first conductive path 371 may correspond to a conductive path, a feeding line, and/or a transmission line for feeding power to the first side portion 231. For example, the first conductive line 361 and the first conductive path 371 may be connected to the second conductive connection member 353 (e.g., a C-clip and/or a conductive foam) and form at least a portion of a conductive path, a feeding line, or a transmission line for feeding power to the first side portion 231. For example, the first conductive line 361 and the first conductive path 371 may be configured to be connected to the second conductive connection member 353 and allow the wireless communication circuit 321 to perform wireless communication.

According to an embodiment, in the first fill-cut region 353a, as at least a portion of the non-conductive material (or dielectric material) formed on the surface of the first conductive connection member 350 is removed, the first conductive path 371 may be exposed to the outside of the first conductive connection member 350, and the first conductive path 371 exposed to the outside of the first conductive connection member 350 may be electrically connected to the second conductive connection member 353.

For example, the second conductive connection member 353 may include a C-clip, a conductive gasket, or a pogo pin.

According to an embodiment, the side key 217 may include a conductive portion 341 and a non-conductive portion 342 disposed along an edge of the conductive portion 341. For example, the conductive portion 341 may include a substrate or panel for allowing the side key 217 to identify a user input (e.g., a touch input). For another example, the conductive portion 341 may include a metal layer included in the side key 217.

For example, the non-conductive portion 342 may be formed to surround the conductive portion 341. When the side key 217 is disposed in the groove 250, the non-conductive portion 342 may be located between the side member 215 and the conductive portion 341, and may secure a separation distance between the side member 215 and the conductive portion 341. For example, the non-conductive portion 342 may be used to secure the separation distance between the groove 250 of the side member 215 and the conductive portion 341.

According to an embodiment, the non-conductive portion 342 may include an adhesive material (e.g., a non-conductive adhesive member and a non-conductive adhesive tape).

According to an embodiment, the adhesive material of the non-conductive portion 342 may fix the side key 217 to the groove 250. For example, when the side key 217 is entered in the groove 250, the non-conductive portion 342 may contact the first side portion 231, and the side key 217 may be fixed to the groove 250 through the adhesive material of the non-conductive portion 342.

The first connection portion 351 and the second connection portion 352 of the first conductive connection member 350 described in FIG. 3B of the disclosure may be replaced with various expressions referring to the portions. For example, the first connection portion 351 and the second connection portion 352 may be replaced with a first portion and a second portion, respectively. For example, the first connection portion 351 and the second connection portion 352 may be replaced with a first part and a second part, respectively.

The term "fill-cut region" of the disclosure may be replaced with one of a cutting area, a cutting portion, a removal portion, a removal area, or a fill-cut area.

The term "conductive path" of the disclosure may be replaced with the term "transmission line", "conductive line", or "feeding path".

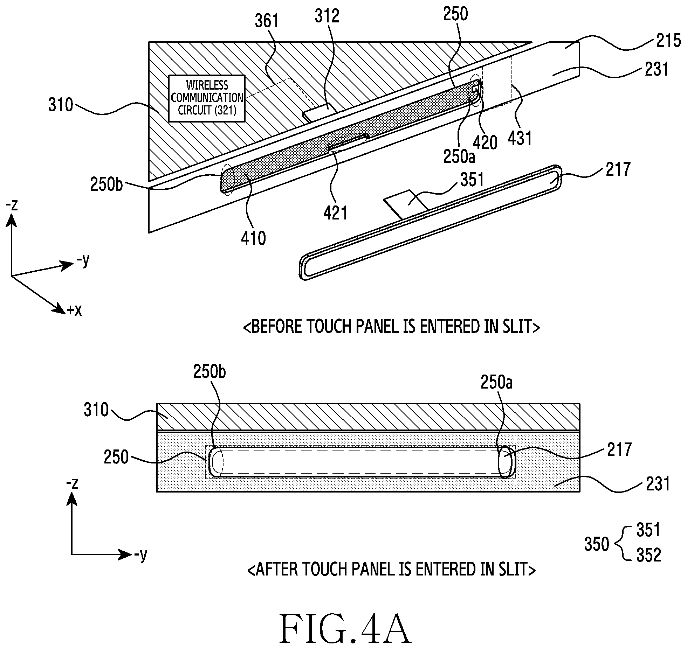

FIG. 4A is a diagram illustrating a side key that is entered in a groove from the outside of an electronic device, according to an embodiment.

Referring to FIG. 4A, the electronic device 101 of an embodiment may include a support member 410, a connector 312, and/or a first protrusion 420.

According to an embodiment, the side key 217 may be entered in the groove 250 from the outside of the electronic device 101 and may be disposed in the groove 250. For example, the side key 217 located outside the electronic device 101 may be moved in a first direction (e.g., -x direction) and be entered in the groove 250, and the side key 217 may be coupled with the groove 250 or be fixed to the groove 250. In an example, after the side key 217 is entered in the groove 250, the non-conductive portion 342 may be disposed between the groove 250 and the conductive portion 341 of the side key 217.

In the disclosure, it has been described that when the side key 217 is entered in the groove 250, the non-conductive portion 342 is disposed between the conductive portion 341 of the side key 217 and the groove 250, but this is only an example. For example, a non-conductive region may be formed or configured along a border or edge of the groove 250. In this case, when the side key 217 is entered in the groove 250, the non-conductive region of the groove 250 may be disposed or located between the groove 250 and the conductive portion 341 of the side key 217.

For another example, the side key 217 located outside the electronic device 101 may be moved in a direction from the outside of the electronic device 101 to the inner space of the electronic device 101 and be entered in the groove 250, and the side key 217 may be coupled with the groove 250. For another example, the side key 217 located outside the electronic device 101 may be moved in a direction toward the groove 250 and be entered in the groove 250, and the side key 217 may be coupled with the groove 250.

According to an embodiment, the electronic device 101 may include the support member 410. The support member 410 may support the side key 217 entered in the groove 250 or may fix the side key 217 to the groove 250. For example, the support member 410 may contact a rear face (e.g., the rear face 217b of FIG. 3B) of the side key 217, and may support the side key 217 or fix the side key 217 to the groove 250.

According to an embodiment, the support member 410 may include a hole 421 in which the first connection portion 351 of the first conductive connection member 350 is entered. When the side key 217 is entered in the groove 250, the first conductive connection member 350 of the side key 217 may be entered in the hole 421 and be connected to the connector 312.

According to an embodiment, the electronic device 101 may include the connector 312. For example, the connector 312 may be formed or disposed on the first printed circuit board 310. For example, the connector 312 may include a component for providing electrical connection between the side key 217 and components (e.g., the wireless communication circuit 321 and the processor 120) disposed on the first printed circuit board 310.

According to an embodiment, the connector 312 may electrically connect the wireless communication circuit 321 to the side key 217. For example, the wireless communication circuit 321 may be electrically connected to the connector 312 through the first conductive line 361, and the side key 217 may be electrically connected to the connector 312 through the first conductive connection member 350. As a result, the wireless communication circuit 321 may be electrically connected to the side key 217 through the first conductive line 361, the connector 312, and the first conductive connection member 350.

According to an embodiment, the side member 215 may include the first protrusion 420. For example, the first side portion 231 of the side member 215 may include the first protrusion 420.

According to an embodiment, the first protrusion 420 may include a portion extending from the side member 215 by a specified length. For example, the first protrusion 420 may include a portion extending from the first side portion 231 of the side member 215 in a first direction (e.g., +y direction). For example, the first protrusion 420 may include a portion extending by a specified length from an adjacent portion 431, adjacent to a first end 250a of the groove 250, of the side member 215. For example, the first protrusion 420 may include a portion extending from the adjacent portion 431 in a direction from the first end 250a of the groove 250 toward a second end 250b. For example, the first protrusion 420 may include a portion extending in a direction (e.g., +y direction) parallel to the first side portion 231.

In the disclosure, the term "support member 410" may be replaced with the term "support plate", "support substrate", "plate", or "substrate".

The term "protrusion" of the disclosure may be replaced with "protruding portion", "extension", or "extended portion".

The interior or inner space of the electronic device 101 of the disclosure may be referred to as a space surrounded by the display 201, the rear cover 211, and the side member 215. Also, the exterior or outer space of the electronic device 101 may be referred to as a space other than the space surrounded by the display 201, the rear cover 211, and the side member 215.

The term "adjacent portion 431" of FIG. 4A of the disclosure may be replaced with other terms referring to a portion of the side member 215 adjacent to the groove 250. Also, the size or shape of the adjacent portion 431 of FIG. 4A is illustrated for convenience of explanation and therefore, the size or shape of the adjacent portion 431 may vary.

FIG. 4B is a diagram illustrating a wireless communication circuit that feeds power to a first side portion when a side key is entered in a groove, according to an embodiment.

Referring to FIG. 4B, the side key 217 located outside the electronic device 101 of an embodiment may be moved in a first direction (e.g., -x direction) and be entered in the groove 250. For example, the side key 217 disposed outside the electronic device 101 may be moved in a direction (e.g., -x direction) toward the groove 250 and be coupled with the groove 250 or fixed to the groove 250.

According to an embodiment, as the side key 217 is entered in the groove 250, the second conductive connection member 353 located in the first fill-cut region 353a of the first conductive connection member 350 may be electrically connected to the first protrusion 420. For example, as the side key 217 moves in the first direction (e.g., -x direction), the second conductive connection member 353 may contact the first protrusion 420. The second conductive connection member 353 may be electrically connected to the first protrusion 420.

According to an embodiment, the wireless communication circuit 321 may feed power to a first point F1 of the first side portion 231 through the first conductive connection member 350 of the side key 217. For example, the wireless communication circuit 321 may be electrically connected to the second conductive connection member 353 (e.g., a conductive gasket) through the first conductive line 361 and the first conductive path 371. Since the second conductive connection member 353 is electrically connected to the first protrusion 420 of the first side portion 231, the wireless communication circuit 321 may feed power to the first point F1 through the first conductive path 371, the second conductive connection member 353, and the first protrusion 420.

According to an embodiment, the first point F1 may include a point adjacent to the groove 250 of the side member 215. For example, the first point F1 may include a point adjacent to the groove 250 of the first side portion 231. For example, the first point F1 may include a point adjacent to the first end 250a of the groove 250. For example, the first point F1 may be included in a first portion (e.g., a first portion 510 of FIG. 5) of the side member 215 described below in FIG. 5.

According to an embodiment, the wireless communication circuit 321 may transmit and/or receive RF signals in a specified frequency band (e.g., about 3 GHz to about 6 GHz), based on an electrical path that is formed in a portion (e.g., the first portion 510 of FIG. 5) of the side member 215 corresponding to the groove 250 and a conductive portion (e.g., the conductive portion 341 of FIG. 3B) of the side key 217 by feeding power to the first point F1 of the first side portion 231.

The electrical path formed in the first portion 510 and the conductive portion 341 is described below with reference to FIG. 5.

The specified frequency band of the disclosure may include various frequency bands. For example, the specified frequency band may include a frequency band of about 3 GHz to about 6 GHz. For example, the specified frequency band may include at least a portion of an FR1 band (e.g., about 7.125 GHz or less). For example, the specified frequency band may include at least a portion of an FR2 band (e.g., about 24.25 GHz to about 52.6 GHz).

In FIG. 4B of the disclosure, it has been described that the wireless communication circuit 321 feeds power to the first point F1 of the first side portion 231, but the wireless communication circuit 321 may also be expressed as feeding power to the first point F1 of the side member 215. Also, the wireless communication circuit 321 may feed power to various points of the first side portion 231 other than the first point.

FIG. 5 is a diagram illustrating an electrical path that is formed in a side member and a conductive portion of a side key as a wireless communication circuit feeds power to the side member, according to an embodiment.

Referring to FIG. 5, the side member 215 of an embodiment may include the first portion 510 that includes a conductive material. For example, the side member 215 may include the first portion 510 that surrounds an edge of the groove 250. For example, the side member 215 may include the first portion 510 that corresponds to or includes the edge of the groove 250. For example, the side member 215 may include the first portion 510 that includes the groove 250. For example, the side member 215 may include the first portion 510 in which the groove 250 is formed. For example, the side member 215 may include the first portion 510 that is adjacent to the groove 250. For example, the side member 215 may include the first portion 510 that includes the first point F1 for feeding power. For example, the side member 215 may include the first portion 510 that includes an electrical path formed along the edge of the groove 250.

According to an embodiment, the wireless communication circuit 321 may feed power to the first point F1 of the side member 215. For example, the wireless communication circuit 321 may feed power to the first point F1 of the first portion 510 of the side member 215.

The first portion 510 of the disclosure is a term referring to a region or portion surrounding the groove 250 of the side member 215. The size and boundary of the first portion 510 illustrated in FIG. 5 of the disclosure may vary. For example, the first portion 510 may have a size and boundary different from the size and boundary disclosed in FIG. 5. For another example, the first portion 510 may have various shapes other than a rectangle.

According to an embodiment, as the wireless communication circuit 321 feeds power to the first point F1 of the side member 215, a first electrical path 521 may be formed in the first portion 510 of the side member 215, and a second electrical path 522 may be formed in the conductive portion 341 of the side key 217. For example, when the side key 217 is seated in the groove 250, the non-conductive portion 342 may be formed between the first side portion 231 and the conductive portion 341. The non-conductive portion 342 may substantially form a slit. The wireless communication circuit 321 may feed power to the first point F1 across the non-conductive portion 342 forming the slit, thereby forming an electrical path around the non-conductive portion 342. In an example, the first electrical path 521 may be formed in the first portion 510, and the second electrical path 522 may be formed in the conductive portion 341. In this case, an antenna 501 (or slot antenna) including the first portion 510 and the conductive portion 341 as a radiator may operate based on the first electrical path 521 and the second electrical path 522.

For example, as the wireless communication circuit 321 feeds power to the first point F1 of the first portion 510, the first electrical path 521 may be formed along an edge of the groove 250, and the second electrical path 522 may be formed along an edge of the conductive portion 341.

For example, when the wireless communication circuit 321 feeds power to the first point F1 of the first portion 510, a current may flow from the first portion 510 to the conductive portion 341 through coupling connection or electromagnetic connection, due to a potential difference between the first point F1 adjacent to the groove 250 and the conductive portion 341. Accordingly, the first electrical path 521 and the second electrical path 522 may be formed.

Hereinafter, in the disclosure, an antenna radiator that transmits and/or receives RF signals in a specified frequency band, based on the first electrical path 521 and the second electrical path 522, is referred to as the antenna 501. That is, in the following, the antenna 501 may include an antenna radiator that includes the first portion 510 of the side member 215 and the conductive portion 341 of the side key 217. For another example, the antenna 501 may include an antenna radiator that includes the first portion 510 and the conductive portion 341.

According to an embodiment, the first portion 510 of the side member 215 may be spaced apart from the conductive portion 341 of the side key 217 with the non-conductive portion 342 of the side key 217 located therebetween. For example, the first portion 510 and the conductive portion 341 may be spaced apart from each other wherein electromagnetic connection is enabled. For another example, the first portion 510 and the conductive portion 341 may be spaced apart from each other by a specified distance wherein capacitive connection is enabled. For further example, the first portion 510 and the conductive portion 341 may be disposed to be spaced apart from each other by a specified distance wherein coupling connection is enabled.

According to an embodiment, the ground 530 may be electrically connected to the conductive portion 341 of the side key 217. For example, the ground 530 may include an electronic component (e.g., an FPCB and an FRC) included in the first printed circuit board 310 and/or the electronic device 101.

According to an embodiment, the wireless communication circuit 321 may transmit and/or receive RF signals, based on or by using the electrical path 520. For example, a frequency band of the transmitted and/or received RF signals may be based on the length of the electrical path 520.

The electrical path of the disclosure may be understood as the flow of a current formed based on feeding power or the flow of a current formed based on a potential difference.

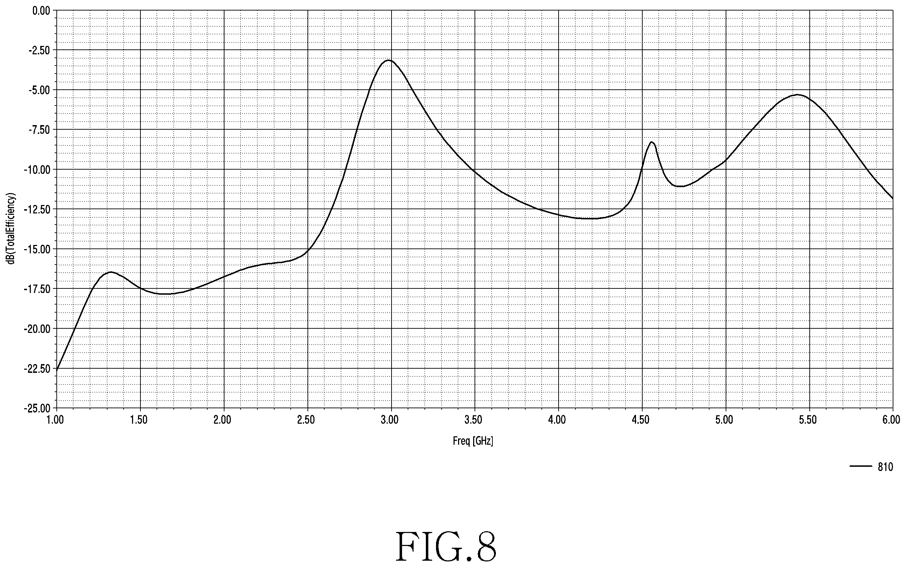

In FIG. 5 of the disclosure, it has been described that the ground 530 is electrically connected to the conductive portion 341 of the side key 217, but this is only an example. For example, the ground 530 may be electrically connected to the conductive portion 341 other than a point shown in FIG. 8. For example, the ground 530 may be electrically connected to one point of the first side portion 231 of the side member 215.

In FIG. 5 of the disclosure, it has been described that as the wireless communication circuit 321 feeds power to the first point F1 of the side member 215, the first electrical path 521 is formed in the first portion 510 of the side member 215, but this is only an example. For example, a description may be made based on the first side portion 231 rather than the side member 215. For example, it may also be described that as the wireless communication circuit 321 feeds power to the first point F1 of the first side portion 231, the first electrical path 521 is formed in the first portion 510 of the first side portion 231.

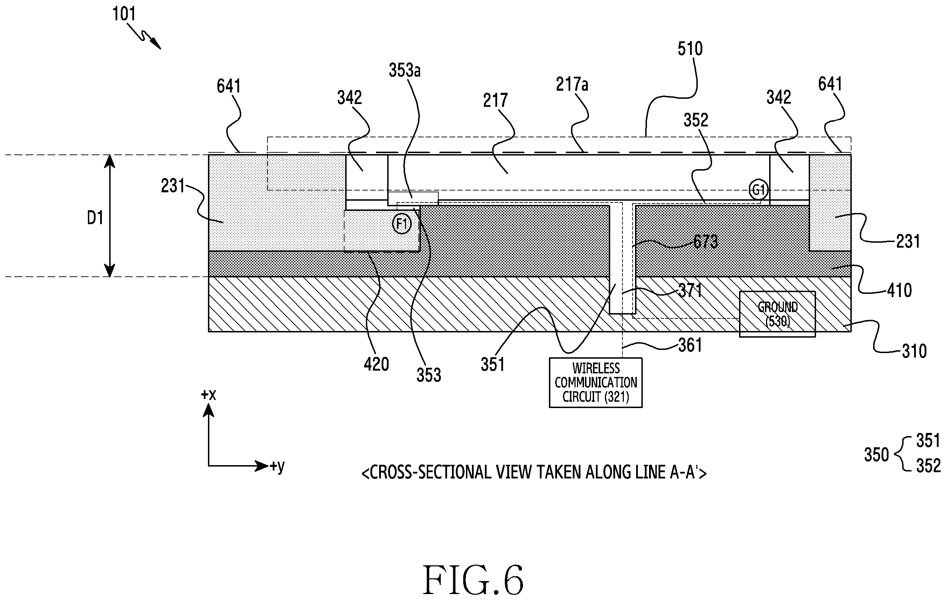

FIG. 6 is a cross-sectional view taken along line A-A' of a first portion, according to an embodiment.

Referring to FIG. 6, the first protrusion 420 of an embodiment may be formed to extend from the first side portion 231 in a third direction (e.g., +y direction).

According to an embodiment, the first conductive path 371 may be formed in the first fill-cut region 353a formed in the second connection portion 352 of the first conductive connection member 350. For example, the first conductive path 371 may be disposed or formed in the first fill-cut region 353a and contact another connection member (e.g., the second conductive connection member 353).

According to an embodiment, the second conductive connection member 353 may be disposed between the first protrusion 420 and the second connection portion 352. For example, the second conductive connection member 353 may be disposed between the first protrusion 420 and the first fill-cut region 353a of the second connection portion 352. For example, the second conductive connection member 353 may be disposed between the first protrusion 420 and the first conductive path 371 formed in the first fill-cut region 353a.

For another example, the second conductive connection member 353 may be located in a second direction (e.g., +x direction) based on the first fill-cut region 353a. In this case, the first protrusion 420 may be located in the second direction (e.g., +x direction) based on the second conductive connection member 353.

According to an embodiment, the ground 530 may be formed on the first printed circuit board 310. For example, the first printed circuit board 310 may include a plurality of conductive layers and non-conductive layers arranged alternately, and at least some of the plurality of conductive layers may correspond to the ground 530.

In FIG. 6 of the disclosure, it has been described that the ground 530 is formed on or is included in the first printed circuit board 310, but this is only an example. For example, the ground 530 may be formed on the second printed circuit board 311. For another example, the ground 530 may be formed on other electrical objects or conductive portions included in the electronic device 101.

According to an embodiment, the ground 530 may be connected at a second point G1 to the side key 217. For example, the ground 530 may be electrically connected at the second point G1 to the side key 217 through a third conductive path 673. An electrical path from the side key 217 to the ground 530 may substantially include a ground path of a conductive portion (e.g., the conductive portion 341 of FIG. 5) of the side key 217.

According to an embodiment, a first side face 641 formed by the first side portion 231 and the front face 217a of the side key 217 may form substantially the same plane. For example, the first side face 641 and the front face 217a may be located on substantially the same plane. For example, the first side face 641 and the front face 217a may form substantially the same face without steps. The first side face 641 of FIG. 6 of the disclosure may substantially correspond to the first side face 241 of FIG. 2C.

For another example, the first side face 641 of the electronic device 101 and the front face 217a of the side key 217 may be spaced apart from an edge 620 of the first printed circuit board 310 by substantially the same distance. For example, the first side face 641 may be spaced apart from the edge 620 of the first printed circuit board 310 by a first distance D1. The front face 217a may be spaced apart from the edge 620 of the first printed circuit board 310 by the first distance D1.

According to an embodiment, as the first side face 641 and the front face 217a of the side key 217 are formed seamlessly on the same plane without steps, the electronic device 101 may prevent or reduce the introduction of external foreign substances (e.g., water or dust) into the electronic device 101.

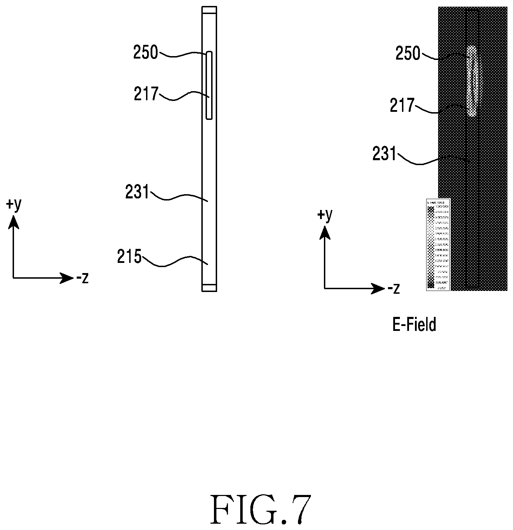

FIG. 7 illustrates a current distribution that is formed along an edge of a groove and an edge of a side key when a wireless communication circuit feeds power to a side member including the groove, according to an embodiment.

Referring to FIG. 7, the wireless communication circuit 321 of an embodiment may feed power to the side member 215 including the groove 250, and a current may be formed along the edge of the groove 250 and the edge of the side key 217, based on feeding power.

The wireless communication circuit 321 may transmit and/or receive RF signals in a specified frequency band, based on the current formed along the edge of the groove 250 and the edge of the side key 217.

FIG. 8 is a graph of radiation efficiency when a wireless communication circuit feeds power to a side member including a groove, according to an embodiment.

Referring to FIG. 8, a first graph 810 of an embodiment is a graph of radiation efficiency of the antenna 501 that includes the first portion 510 and the conductive portion 341 of the side key 217, when the wireless communication circuit 321 feeds power to the first portion 510 of the side member 215.

According to an embodiment, the first graph 810 shows a value of about -15 dB or more in a frequency band of about 2.5 GHz to about 6 GHz. Accordingly, the wireless communication circuit 321 may secure a radiation efficiency of a specified value (e.g., about - 15 dB) or more by using the antenna 501 that includes the first portion 510 and the conductive portion 341.

However, the frequency band of about 2.5 GHz to about 6 GHz is only an example, and an operating frequency band of the antenna 501 is not limited to the frequency band of about 2.5 GHz to about 6 GHz. For example, the frequency band in which the wireless communication circuit 321 transmits and/or receives using the antenna 501 including the first portion 510 and the conductive portion 341 may vary. For example, the wireless communication circuit 321 may transmit and/or receive RF signals in a frequency band of about 2.5 GHz or less. For example, the wireless communication circuit 321 may transmit and/or receive RF signals in a frequency band of about 6 GHz or more.

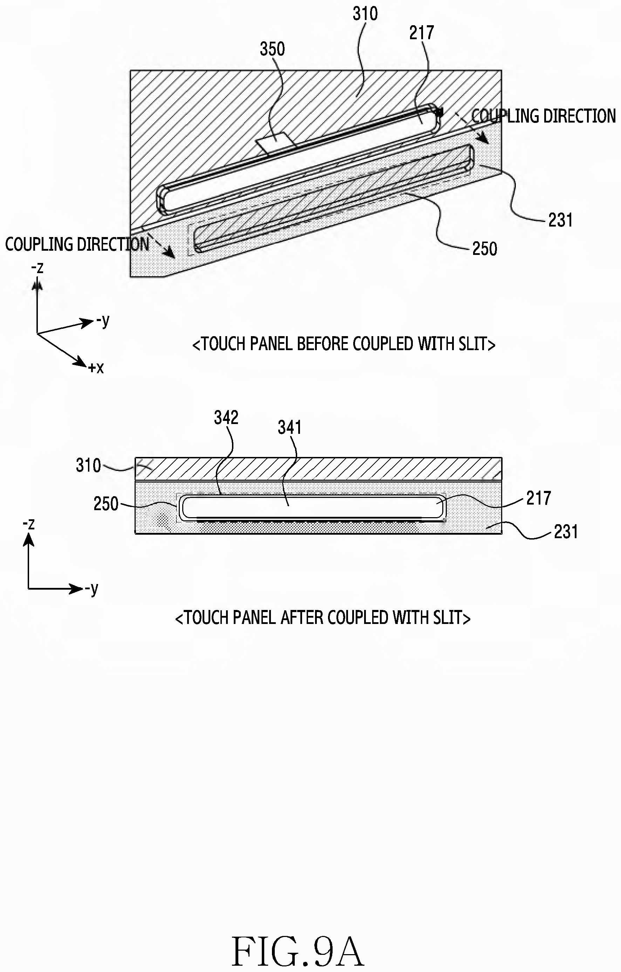

FIG. 9A is a diagram illustrating a side key that is coupled with a groove in a direction from the inside of an electronic device toward the outside of the electronic device, according to an embodiment.

Referring to FIG. 9A, the side key 217 of an embodiment may be coupled with or fixed to the groove 250 in a direction (e.g., +x direction) from the inside of the electronic device 101 toward the outside. For example, the side key 217 located inside the electronic device 101 may be moved in a second direction (e.g., +x direction) and be entered in the groove 250. For another example, the side key 217 located inside the electronic device 101 may be moved in a direction (e.g., +x direction) toward the groove 250 and be entered in or coupled with the groove 250.

In the embodiment of FIG. 9A of the disclosure, unlike the embodiment of FIG. 4A, the side key 217 may be coupled with the groove 250 inside the electronic device 101. For example, in the embodiment of FIG. 4A, the side key 217 may be moved in the first direction (e.g., -x direction) and be coupled with the groove 250, outside the electronic device 101. On the other hand, in the embodiment of FIG. 9A, the side key 217 may be moved in the second direction (e.g., +x direction) and be coupled with the groove 250, inside the electronic device 101.

According to an embodiment, the conductive portion 341 of the side key 217 coupled with the groove 250 may be spaced apart from the groove 250 by a specified distance. For example, even if the side key 217 is entered in the groove 250 and coupled with the groove 250, the non-conductive portion 342 may be disposed between the groove 250 and the conductive portion 341. In this case, the conductive portion 341 may be spaced apart from the first side portion 231 by a distance corresponding to the thickness of the non-conductive portion 342, with the non-conductive portion 342 interposed therebetween.

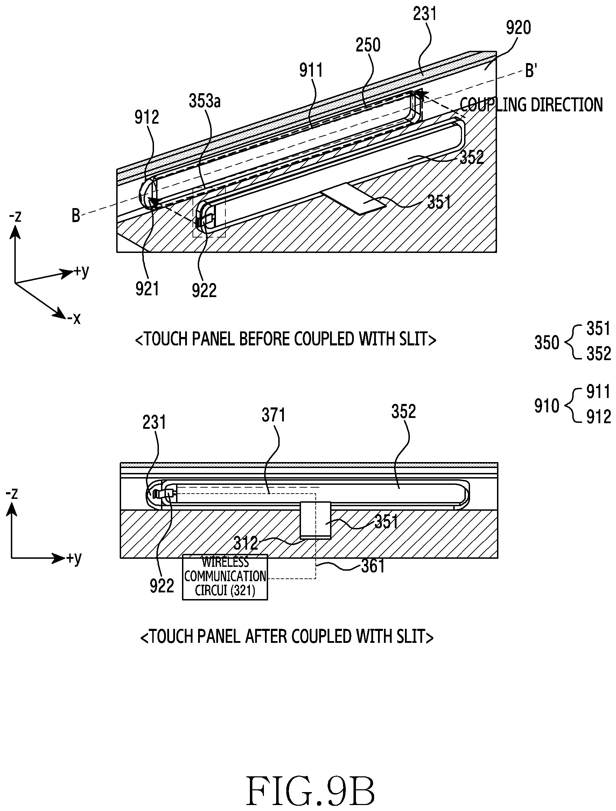

FIG. 9B is a diagram illustrating a fixing member for fixing a groove when a side key is coupled with the groove inside an electronic device, according to an embodiment.

Referring to FIG. 9B, the electronic device 101 of an embodiment may include an injection member 920. For example, the injection member 920 may include a non-conductive material formed on the first side portion 231. For example, the injection member 920 may include a member anodized to the first side portion 231. For example, the injection member 920 may include a double injection member.

For example, the injection member 920 may be formed in a location corresponding to the location of the first side portion 231. For example, at least a portion of the injection member 920 may be disposed to contact the first side portion 231. For example, the injection member 920 may be disposed to be aligned with the first side portion 231. For example, the injection member 920 may be formed to extend lengthwise in a third direction (e.g., +y direction) corresponding to the first side portion 231.

According to an embodiment, the injection member 920 may include an opening 910 that at least partially overlaps the groove 250 formed in the first side portion 231. For example, the opening 910 of the injection member 920 may include a first region 911 and a second region 912. The first region 911 may overlap the groove 250 in a first direction (e.g., - x direction), and the second region 912 may extend from the first region 911 and may not overlap the groove 250. For example, the opening 910 may include the second region 912 that extends from the first region 911 and overlaps the first side portion 231.

For example, the first region 911 may include a region that overlaps the groove 250 in a direction from the inside of the electronic device 101 toward the groove 250, and the second region 912 may include a region that extends from the first region 911 and does not overlap with the groove 250.

For another example, the first region 911 may include a region formed in the injection member 920 and corresponding to the groove 250, and the second region 912 may include a recess additionally formed in the first region 911.

According to an embodiment, the first region 911 of the opening 910 may include a region for passing the side key 217. For example, the side key 217 may pass through the first region 911 of the opening 910 of the injection member 920 and be fixed to or coupled with the groove 250.

According to an embodiment, the second region 912 of the opening 910 may include a region for electrical connection between the first conductive path 371 of the first conductive connection member 350 and the first side portion 231. For example, as the second region 912 is formed, there may be contact between a fourth conductive connection member 922 (e.g., a C-clip) and the first side portion 231. For example, when the second region 912 is not formed, even if the side key 217 is entered in the groove 250, the fourth conductive connection member 922 may not be electrically connected to the first side portion 231 because of the injection member 920. On the other hand, as the second region 912 of an embodiment is formed, the fourth conductive connection member 922 may be electrically connected to the first side portion 231. That is, the fourth conductive connection member 922 may be electrically connected to the first side portion 231 of the side member 215 through the second region 912.

According to an embodiment, the fourth conductive connection member 922 may extend lengthwise from the second connection portion 352 of the side key 217 in a fourth direction (e.g., -y direction), and may contact the first side portion 231.

In FIGS. 9A and 9B of the disclosure, it has been described that the injection member 920 is formed at the first side portion 231, but this is only an example. For example, the injection member 920 may not be formed at the first side portion 231. For example, the injection member 920 may be omitted.

According to an embodiment, the wireless communication circuit 321 may feed power to the first side portion 231 through the first conductive line 361, the first conductive path 371, and the fourth conductive connection member 922, and may transmit and/or receive RF signals in a specified frequency band.

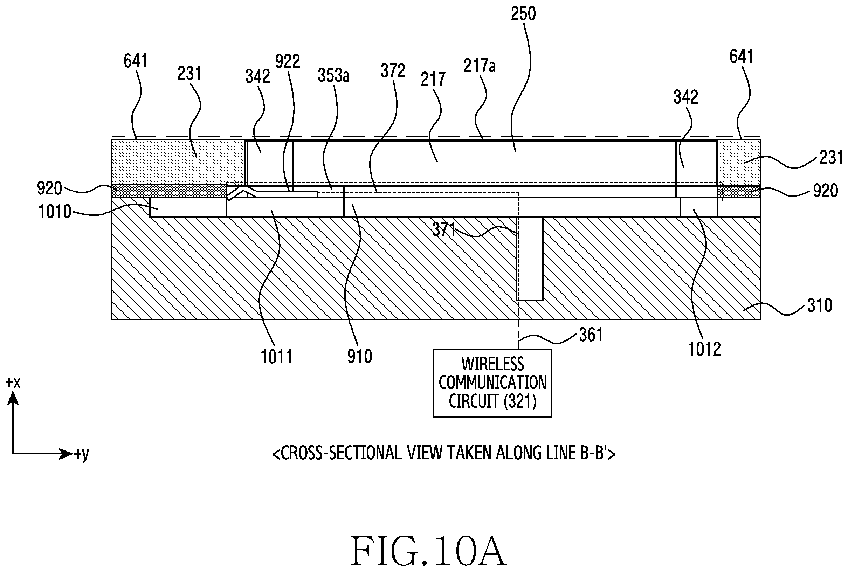

FIG. 10A is a cross-sectional view taken along line B-B' of a side member, according to an embodiment.

Referring to FIG. 10A, the side key 217 of an embodiment may be entered in the groove 250 formed in the first side portion 231 and the opening 910 of the injection member 920. As at least a portion of the side key 217 is entered in the opening 910, the injection member 920 may fix the opening 910.

According to an embodiment, the electronic device 101 may include a support member 1010. For example, the support member 1010 may be disposed to contact a rear face (e.g., the rear face 217b of FIG. 3B) of the side key 217, and may fix the side key 217 into the groove 250.

According to an embodiment, the support member 1010 may include a conductive material and/or a non-conductive material. For example, the entire support member 1010 may be formed of a conductive material. For another example, the support member 1010 may include a conductive material and a non-conductive material. For further example, the entire support member 1010 may be formed of a non-conductive material (e.g., an injection member).

For example, the support member 1010 may include a first non-conductive material 1011 and a second non-conductive material 1012. The first non-conductive material 1011 and the second non-conductive material 1012 may be formed in a location corresponding to the non-conductive portion 342 of the side key 217. For example, the first non-conductive material 1011 and the second non-conductive material 1012 may be located or formed in a first direction (e.g., -x direction) based on the non-conductive portion 342 of the side key 217. For example, the first non-conductive material 1011 and the second non-conductive material 1012 may be located or formed to be aligned with the non-conductive portion 342 of the side key 217. For example, the first direction (e.g., -x direction) may include a direction perpendicular to the first side portion 231. For example, the first direction may include a direction toward the inside of the electronic device 101 based on the first side portion 231.

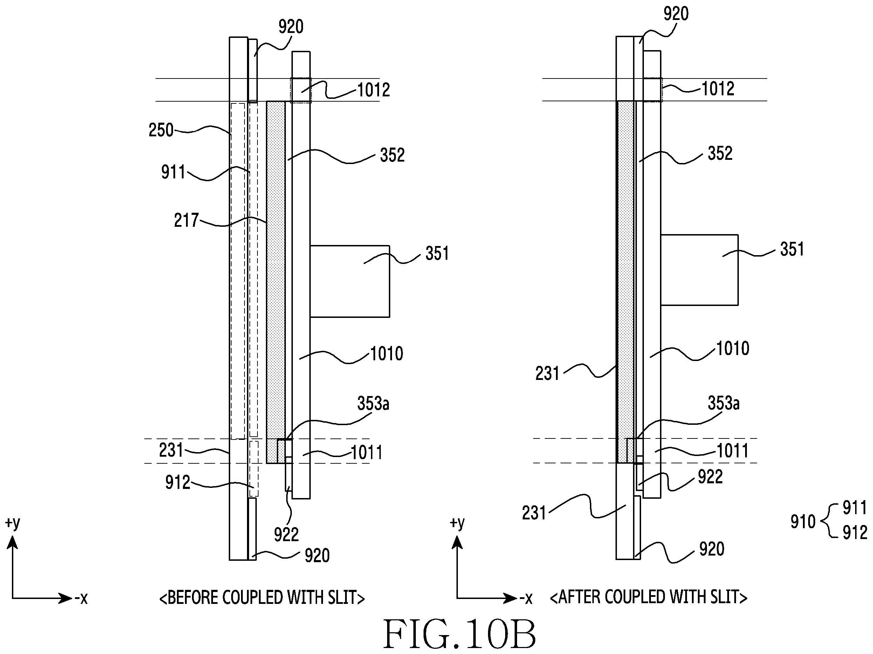

FIG. 10B is a diagram illustrating before and after a side key is entered in a groove shown in FIG. 10A, according to an embodiment.

Referring to FIG. 10B, the side key 217 disposed in the electronic device 101 of an embodiment may be moved in a second direction (e.g., +x direction) and be entered in the groove 250, and may be coupled with the groove 250.

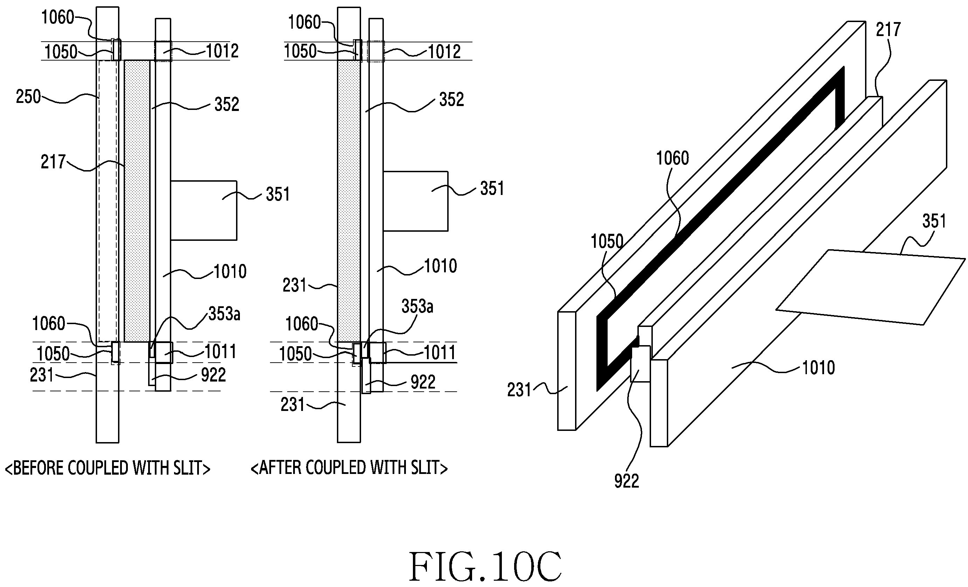

FIG. 10C is a diagram illustrating a process in which a side key is entered in a groove when a fixing member is formed within a first side portion, according to an embodiment.

Referring to FIG. 10C, the electronic device 101 of an embodiment may include a non-conductive member 1050 disposed in the first side portion 231. For example, a recess 1060 may be formed in the first side portion 231, and the non-conductive member 1050 may be disposed in the recess 1060. For another example, the recess 1060 may be filled with the non-conductive member 1050 (e.g., an injection member).

In FIG. 10C of the disclosure, unlike the embodiment of FIG. 3B, the non-conductive member 1050 arranged between the conductive portion 341 of the side key 217 and the first side portion 231 may be formed in the first side portion 231. For example, in the embodiment of FIG. 3B, the non-conductive portion 342 arranged between the conductive portion 341 and the first side portion 231 may be included in the side key 217. On the other hand, in the embodiment of FIG. 10C, the non-conductive member 1050 arranged between the conductive portion 341 and the first side portion 231 may be included in the first side portion 231.

In the embodiment of FIG. 10C of the disclosure, unlike the embodiments of FIGS. 10A and 10B, the non-conductive member 1050 may be arranged within the first side portion 231. For example, in the embodiments of FIGS. 10A and 10B, the non-conductive portion 342 is arranged within the side key 217, whereas in the embodiment of FIG. 10C, the non-conductive member 1050 may be arranged within the recess 1060 formed in the first side portion 231. That is, in the embodiments of FIGS. 10A and 10B, a non-conductive material arranged between the groove 250 and the side key 217 may correspond to the non-conductive portion 342 of the side key 217, and in the embodiment of FIG. 10C, a non-conductive material arranged between the groove 250 and the side key 217 may include the non-conductive member 1050.

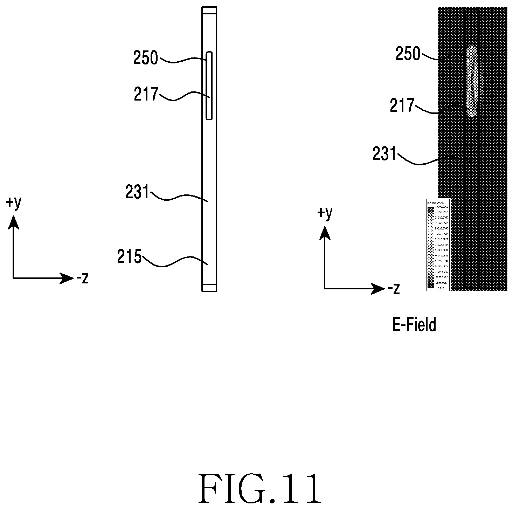

FIG. 11 illustrates a current distribution that is formed along an edge of a groove and an edge of a side key when a wireless communication circuit of FIG. 10A feeds power to a side member including the groove, according to an embodiment.

Referring to FIG. 11, the wireless communication circuit 321 of an embodiment may feed power to the side member 215 including the groove 250, and a current may be formed along an edge of the groove 250 and an edge of the side key 217, based on feeding power.

Referring to the current distribution diagram shown in FIG. 11, it is identified that a current is formed along the edges of the groove 250 and the side key 217, similarly to the current distribution diagram shown in FIG. 7.

Therefore, as in the embodiment of FIG. 10A, even when the side key 217 is moved from the inside of the electronic device 101 toward the groove 250 and is coupled with the groove 250, a current may be formed along edges of the first side portion 231 where the groove 250 is formed and the side key 217, similarly to when the side key 217 is moved from the outside of the electronic device 101 toward the groove 250 and is coupled with the groove 250

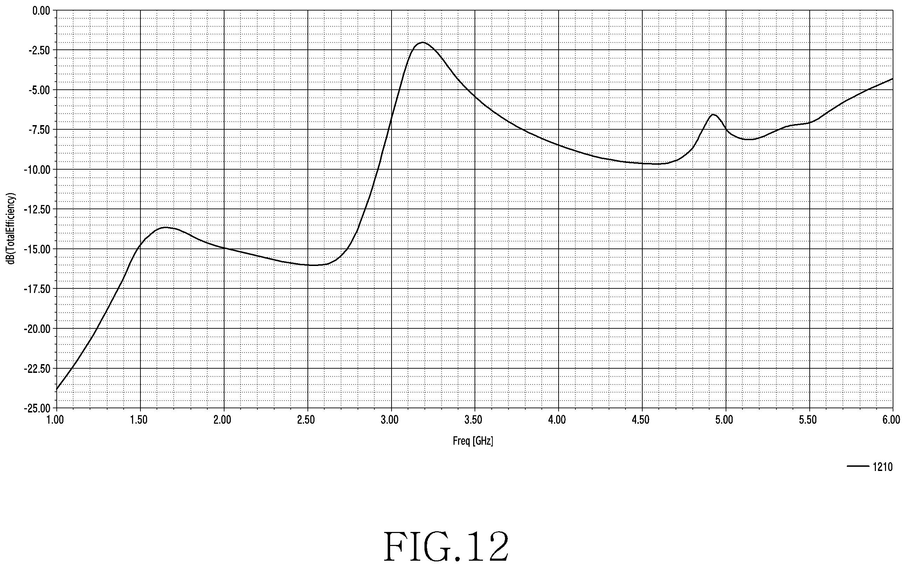

FIG. 12 is a graph of radiation efficiency when a wireless communication circuit of FIG. 10A feeds power to a side member including a groove, according to an embodiment.

Referring to FIG. 12, a first graph 1210 of an embodiment is a graph of radiation efficiency of the antenna 501 that includes the groove 250 and the conductive portion 341 of the side key 217, when the side key 217 is coupled with the groove 250 within the electronic device 101.

According to an embodiment, the first graph 1210 shows a value of about -15 dB or more in a frequency band of about 2.75 GHz to about 6 GHz. Accordingly, the wireless communication circuit 321 may secure a radiation efficiency of a specified value (e.g., about - 15 dB) by using the antenna 501 including the groove 250 and the conductive portion 341.

However, the frequency band of about 2.75 GHz to about 6 GHz is only an example and does not limit the disclosure. The frequency band in which the wireless communication circuit 321 transmits and/or receives using the antenna 501 including the groove 250 and the conductive portion 341 may vary. For example, the wireless communication circuit 321 may transmit and/or receive RF signals in a frequency band of about 2.75 GHz or less. For example, the wireless communication circuit 321 may transmit and/or receive RF signals in a frequency band of about 6 GHz or more.

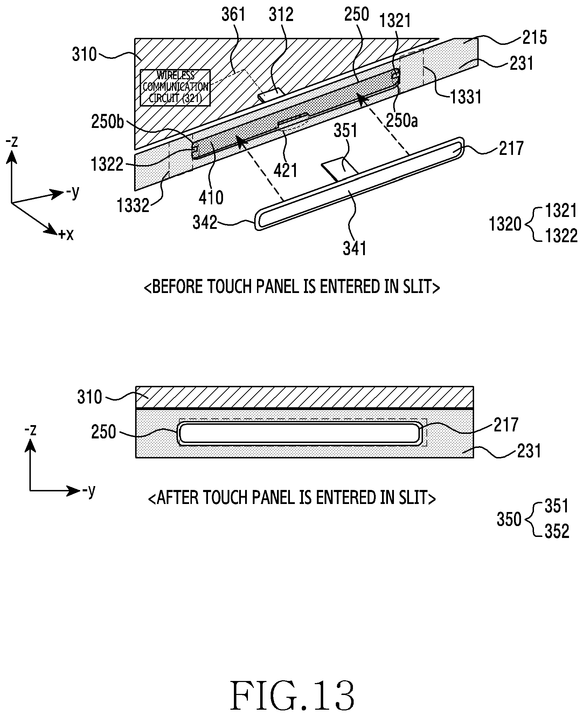

FIG. 13 is a diagram illustrating an electronic device including a second protrusion, according to an embodiment.

Referring to FIG. 13, the electronic device 101 of an embodiment may include a plurality of protrusions 1320. For example, the electronic device 101 may include a first protrusion 1321 extending from a first adjacent portion 1331 of the side member 215 adjacent to the first end 250a of the groove 250. For example, the electronic device 101 may include a second protrusion 1322 extending from a second adjacent portion 1332 of the side member 215 adjacent to the second end 250b of the groove 250. For example, the first adjacent portion 1331 of FIG. 13 of the disclosure may correspond to the adjacent portion 431 of FIG. 4A.

According to an embodiment, the first protrusion 1321 may include a portion formed for the wireless communication circuit 321 to feed power to the side member 215, and the second protrusion 1322 may include a portion formed for grounding.

The first protrusion 1321 of FIG. 13 of the disclosure may correspond to the first protrusion 420 of FIG. 4, and the description of the first protrusion 420 of FIG. 4 may be applied to the first protrusion 1321 of FIG. 13.

According to an embodiment, the first protrusion 1321 may include a portion extending from the first adjacent portion 1331 of the side member 215 by a specified length. For example, the first protrusion 1321 may be formed to extend from the first adjacent portion 1331 in a third direction (e.g., +y direction). For example, the first protrusion 1321 may include a portion extending from the first adjacent portion 1331 in a direction from the first end 250a of the groove 250 toward the second end 250b.

According to an embodiment, the second protrusion 1322 may include a portion extending from the second adjacent portion 1332 of the side member 215 by a specified length. For example, the second protrusion 1322 may be formed to extend from the second adjacent portion 1332 in a fourth direction (e.g., -y direction). For example, the second protrusion 1322 may include a portion extending from the second adjacent portion 1332 in a direction from the second end 250b of the groove 250 toward the first end 250a.

In FIG. 13 of the disclosure, it has been described that the electronic device 101 includes the first protrusion 1321 and the second protrusion 1322 that extend from the side member 215, but this is only an example. For example, the first protrusion 1321 and the second protrusion 1322 may also be described as a concept being included in the side member 215.

The terms "first adjacent portion 1331" and "second adjacent portion 1332" in FIG. 13 of the disclosure may be replaced with other terms referring to portions of the side member 215 adjacent to the groove 250. Also, the size or shape of the first adjacent portion 1331 and the second adjacent portion 1332 in FIG. 13 are shown for convenience of explanation, and the size or shape of the first adjacent portion 1331 and the second adjacent portion 1332 may vary.

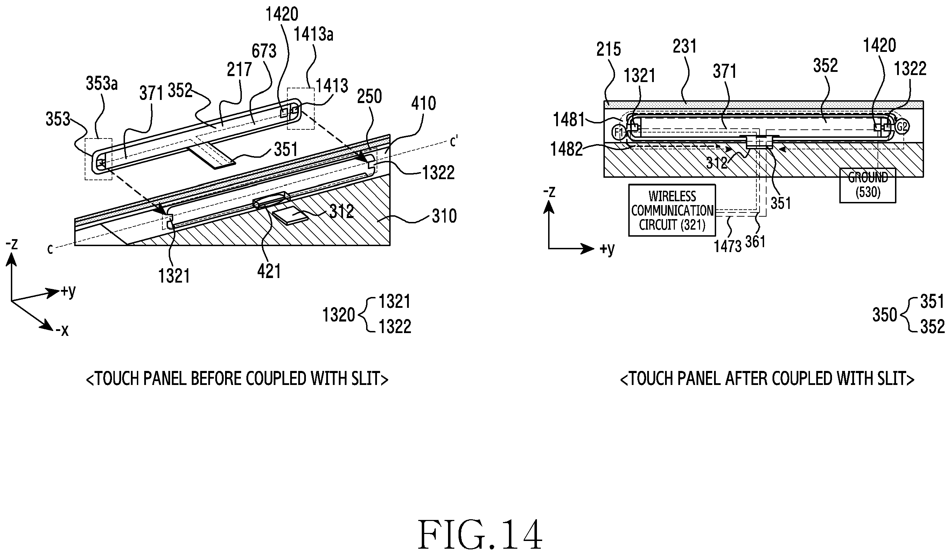

FIG. 14 is a diagram illustrating a side key including a plurality of fill-cut regions and a side member including a plurality of protrusions, according to an embodiment.

Referring to FIG. 14, the side key 217 of an embodiment may include the first conductive connection member 350, and the first conductive connection member 350 may include the first fill-cut region 353a and a second fill-cut region 1413a.

According to an embodiment, the first conductive path 371 may be connected to the second conductive connection member 353 in the first fill-cut region 353a, and a third conductive connection member 1413 may be arranged in and connected to the second fill-cut region 1413a. For example, the second conductive connection member 353 and/or the third conductive connection member 1413 may include at least one of a conductive gasket, a C-clip, or a pogo-pin.

According to an embodiment, when the side key 217 is entered in the groove 250, the second conductive connection member 353 may be connected to the first protrusion 1321, and the third conductive connection member 1413 may be connected to the second protrusion 1322.

According to an embodiment, the wireless communication circuit 321 may feed power to the first point F1 of the side member 215 through the first conductive line 361, the first conductive path 371, the first protrusion 1321, and the second conductive connection member 353.

According to an embodiment, the ground 530 may be electrically connected to the third point G2 of the side member 215 through the second protrusion 1322 and the third conductive connection member 1413.

According to an embodiment, a fourth conductive path 1473 may electrically connect a switch circuit 1420 to the wireless communication circuit 321. For example, the electronic device 101 may include the switch circuit 1420 connected to the wireless communication circuit 321 through the fourth conductive path 1473. For example, the switch circuit 1420 may be formed or arranged in the second connection portion 352 of the side key 217.

According to an embodiment, the wireless communication circuit 321 and/or the processor 120 may transmit a control signal for controlling the switch circuit 1420 through the fourth conductive path 1473. For example, the wireless communication circuit 321 may be connected to the switch circuit 1420 through the fourth conductive path 1473, and may turn on/off the switch circuit 1420 through the control signal and control electrical connection between at least one lumped element within the switch circuit 1420 and the first side portion 231. For example, the processor 120 may control the switch circuit 1420 via the wireless communication circuit 321 or by directly connecting to the switch circuit 1420. According to an embodiment, the switch circuit 1420 may include at least one lumped element (e.g., a capacitor or an inductor), and the switch circuit 1420 may change the electrical length of an antenna (e.g., the antenna 501 of FIG. 5) by using at least one element. For example, the switch circuit 1420 may electrically connect a first inductor having a first inductance value to the first side portion 231 through the third conductive connection member 1413 and the second protrusion 1322, and in this case, the electrical length of the antenna 501 including the first side portion 231 may be relatively increased compared to when the first inductor is not connected. For example, the switch circuit 1420 may electrically connect a second inductor having a second inductance value greater than the first inductance value to the first side portion 231, and in this case, the electrical length of the antenna 501 including the first side portion 231 may be relatively increased compared to when the first inductor is connected. For example, the switch circuit 1420 may connect a capacitor having a first capacitance value to the first side portion 231. In this case, the electrical length of the antenna 501 including the first side portion 231 may be relatively decreased compared to when the capacitor is not connected.

According to an embodiment, as the switch circuit 1420 is turned on and off, the electronic device 101 may secure electrical paths having various electrical lengths, and transmit and/or receive RF signals in multiple frequency bands. For example, when the switch circuit 1420 is turned off, a third electrical path 1481 may be formed. For example, when the switch circuit 1420 is turned on, the ground 530 may be electrically connected to the first side portion 231 through the third conductive connection member 1413 and the second protrusion 1322. In this case, a fourth electrical path 1482 may be formed. As the electrical path for the antenna 501 changes from the third electrical path 1481 to the fourth electrical path 1482, the electrical length of the electrical path for the antenna 501 may be relatively decreased. When the electrical length is decreased, the resonance frequency of RF signals may transit to a relatively high frequency band, and the electronic device 101 may implement multiple frequency bands.

For example, the change of the electrical length of the antenna 501 may be referred to as the change of the length of at least one of the first electrical path 521 or the second electrical path 522 for the antenna 501.

The term "switch circuit" in the disclosure may be replaced with a matching circuit, a matching element, a switching circuit, or a switch module.

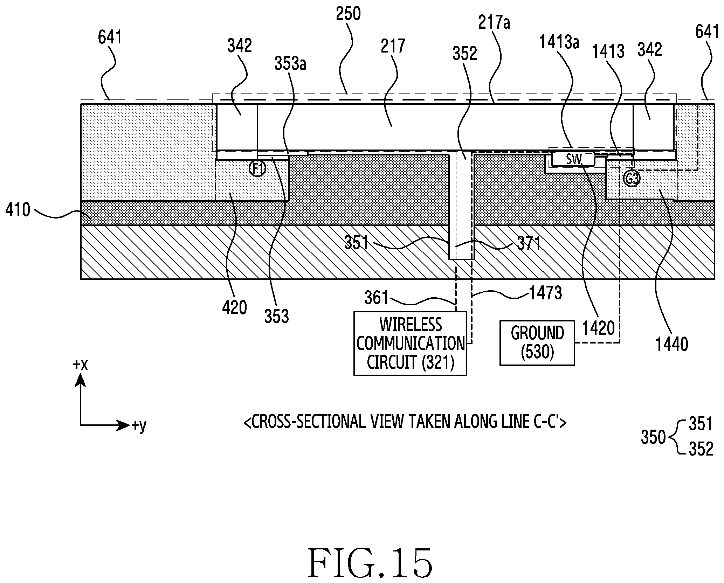

FIG. 15 is a cross-sectional view taken along line C-C' of a side member of FIG. 14, according to an embodiment.

Referring to FIG. 15, the switch circuit 1420 of an embodiment may be formed or disposed on the third conductive path 673. For example, the switch circuit 1420 may be formed on the third conductive path 673 that electrically connects the ground 530 of the first printed circuit board 310 to the third conductive connection member 1413.

In FIG. 15 of the disclosure, it has been described that the switch circuit 1420 is formed on the third conductive path 673, but this is only an example and may be replaced with various expressions. For example, the switch circuit 1420 may include a component included in the third conductive path 673. For another example, the switch circuit 1420 may include a component electrically connected to the third conductive path 673.

According to an embodiment, the third conductive path 673 may be electrically connected to the third conductive connection member 1413 through the second fill-cut region 1413a, and the ground 530 may be electrically connected to a third point G3 of the side member 215 through the third conductive path 673, the switch circuit 1420 and the third conductive connection member 1413.

According to an embodiment, the first conductive path 371 may be electrically connected to the second conductive connection member 353 through the first fill-cut region 353a, and the wireless communication circuit 321 may feed power to the first point F1 of the side member 215 through the first conductive line 361, the first conductive path 371 and the second conductive connection member 353.

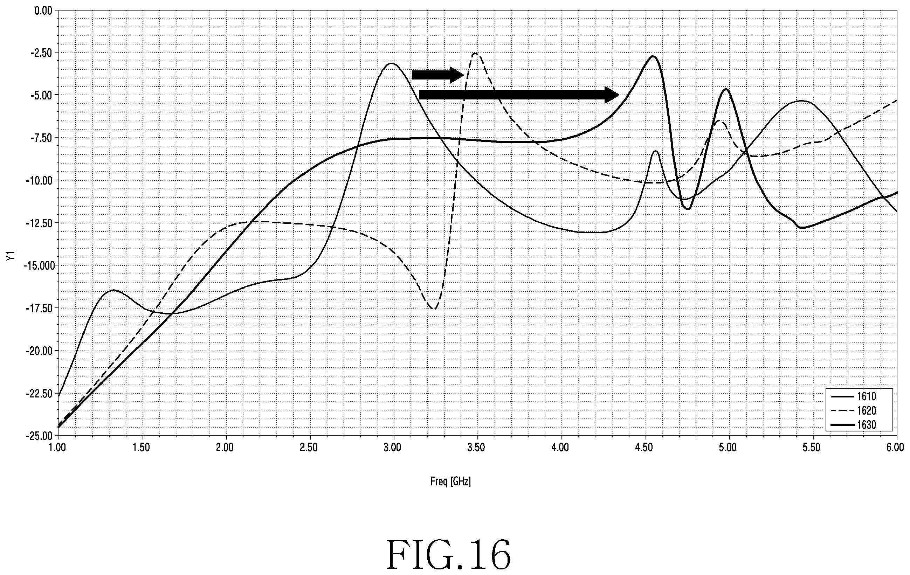

FIG. 16 is a graph of radiation efficiency of an antenna including a groove and a side key dependent on a lumped element connected to a third conductive path, according to an embodiment.

Referring to FIG. 16, a first graph 1610 of an embodiment is a graph of radiation efficiency of the antenna 501 that includes the groove 250 and the side key 217, when the switch circuit 1420 does not electrically connect the second protrusion 1322 to the ground 530. A second graph 1620 is a graph of radiation efficiency of the antenna 501 that includes the groove 250 and the side key 217, when the switch circuit 1420 electrically connects the second protrusion 1322 to the ground 530 through a first inductor having a first inductance value (e.g., about 3.9 nH). A third graph 1630 is a graph of radiation efficiency of the antenna 501 that includes the groove 250 and the side key 217, when the switch circuit 1420 electrically connects the second protrusion 1322 to the ground 530 through a second inductor having a second inductance value (e.g., about 1 nH).

Comparing the first graph 1610 with the second graph 1620, it is identified that the second graph 1620 corresponding to when the first inductor is electrically connected to the third conductive path 673 is shown in a relatively high frequency band compared to the first graph 1610 corresponding to when the second protrusion 1322 is not connected to the ground 530. For example, the first graph 1610 shows the maximum radiation efficiency value at a frequency of about 3 GHz, whereas the second graph 1620 shows the maximum radiation efficiency value at a frequency of about 3.5 GHz.

Comparing the first graph 1610 with the third graph 1630, it is identified that the third graph 1630 when the second inductor is electrically connected to the third conductive path 673 is shown in a relatively high frequency band compared to the first graph 1610 when the second protrusion 1322 is not connected to the ground 530. For example, the first graph 1610 shows the maximum radiation efficiency value at a frequency of about 3 GHz, whereas the third graph 1630 shows the maximum radiation efficiency value at a frequency of about 4.5 GHz.

For example, the electronic device 101 may adjust the operating frequency band of the antenna 501 including the groove 250 and the side key 217, by controlling electrical connection between the lumped elements included in the switch circuit 1420 and the third conductive path 673. For example, the switch circuit 1420 may change the operating frequency band of the antenna 501 by adjusting the electrical length of the antenna 501.

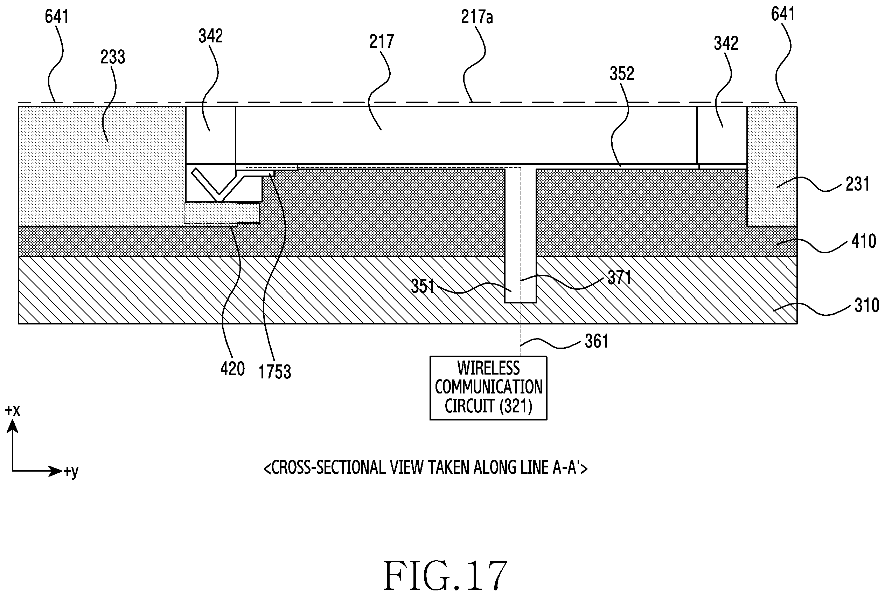

FIG. 17 is a diagram illustrating a C-clip that connects a side member to a wireless communication circuit, according to an embodiment.

Referring to FIG. 17, the electronic device 101 of an embodiment may include a connection structure 1753 (e.g., a C-clip). For example, the connection structure 1753 may be arranged between the first protrusion 420 and the side key 217.

According to an embodiment, the connection structure 1753 may electrically connect the side member 215 to the wireless communication circuit 321. For example, the connection structure 1753 may electrically connect the first protrusion 420 to the first conductive path 371 of the side key 217. Since the first conductive path 371 is connected to the wireless communication circuit 321, the wireless communication circuit 321 may be resultantly connected to the first protrusion 420 of the side member 215 through the connection structure 1753.

In FIG. 6 of the disclosure, the second conductive connection member 353 (e.g., the conductive gasket) connects the first protrusion 420 to the first conductive path 371, whereas in FIG. 17 of the disclosure, the connection structure 1753 (e.g., the C-clip) may connect the first protrusion 420 to the first conductive path 371.

In FIGS. 6 and 17 of the disclosure, it has been described that the second conductive connection member 353 or the connection structure 1753 is arranged between the second connection portion 352 and the first protrusion 420, but this is only an example.

For example, the second conductive connection member 353 or the connection structure 1753 may be omitted, and the first conductive path 371 may be connected to the first protrusion 420 in a coupling or electromagnetic manner. In this case, the wireless communication circuit 321 may coupling feed power to the first protrusion 420 through the first conductive path 371. In this case, when a gap between the first conductive path 371 and the first protrusion 420 is longer than a distance over which a coupling connection is possible, a separate coupler may be also arranged between the first conductive path 371 and the first protrusion 420.

For example, the second conductive connection member 353 or the connection structure 1753 may be omitted, and the first conductive path 371 and the first protrusion 420 may be directly connected through ultrasonic fusion.

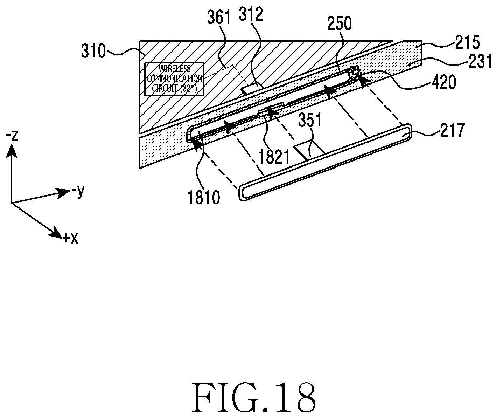

FIG. 18 is a diagram illustrating a support member that supports a side key and includes a conductive material, according to an embodiment.

Referring to FIG. 18, the electronic device 101 of an embodiment may include a support member 1810. For example, the support member 1810 may be arranged to contact a rear face (e.g., the rear face 217b of FIG. 3B) of the side key 217, and may fix the side key 217 into the groove 250.

According to an embodiment, the support member 1810 may include a conductive material. For example, the entire support member 1810 may be formed of a conductive material.

According to an embodiment, the support member 1810 may include a hole 1821 in which the first connection portion 351 of the first conductive connection member 350 is entered. For example, when the side key 217 is entered in the groove 250, the first conductive connection member 350 of the side key 217 may be entered in the hole 1821, and may be connected to the connector 312.

According to an embodiment, the support member 1810 may be formed integrally with or be coupled with the side member 215.

According to an embodiment, the support member 1810 may be at least partially spaced apart from the side member 215, and a non-conductive material or dielectric material may be located between the support member 1810 and the side member 215.

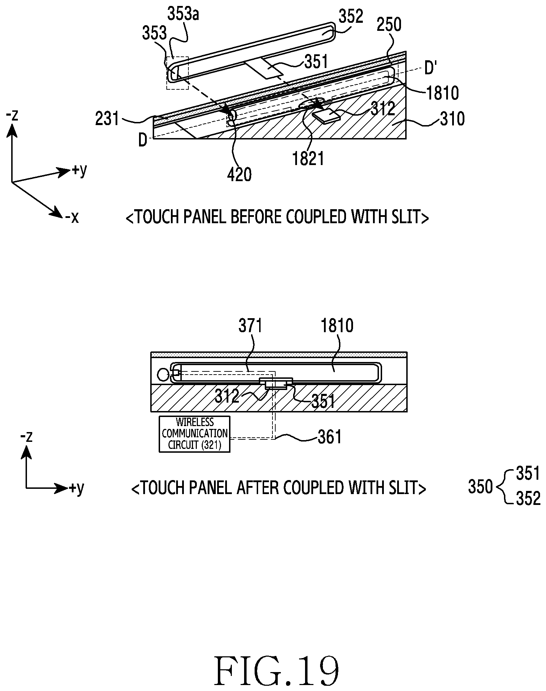

FIG. 19 is a diagram illustrating a side key that is entered in a hole of a support member including a conductive material, according to an embodiment.

Referring to FIG. 19, the side key 217 of an embodiment may be moved in a first direction (e.g., -x direction) and be coupled with the groove 250. The side key 217 arranged within the groove 250 may contact the support member 1810 including the conductive material, and may be fixed within the groove 250 by the support member 1810.

For example, when an external shock or pressure is applied to the electronic device 101, as the support member 1810 supports the side key 217, the side key 217 may be fixed within the groove 250.

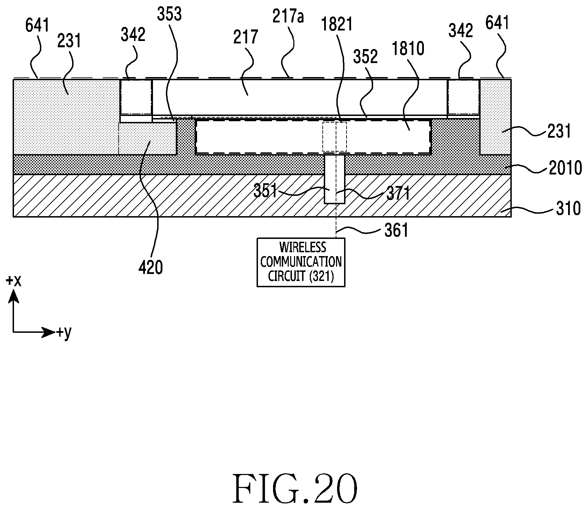

FIG. 20 is a cross-sectional view taken along line D-D' of a first side portion of FIG. 19.

Referring to FIG. 20, the support member 1810 of an embodiment may be in a first direction (e.g., -x direction) based on the side key 217.

According to an embodiment, the electronic device 101 may include a fixing member 2010, and the fixing member 2010 may be in the first direction (e.g., -x direction) based on the support member 1810. For example, the fixing member 2010 may support the support member 1810 or fix the side key 217 arranged within the groove 250 into the groove 250.

According to an embodiment, the fixing member 2010 may include a non-conductive material. For example, the fixing member 2010 may be formed of an injection material. For example, the fixing member 2010 may fix the support member 1810 and the side key 217.

In FIG. 20 of the disclosure, it has been described that the electronic device 101 includes the support member 1810 and the fixing member 2010, but this is only an example. Each of the support member 1810 and the fixing member 2010 may be replaced with the terms "first support member" and "second support member". For another example, the support member 1810 and the fixing member 2010 may be replaced with the terms "first fixing member" and "second fixing member", respectively.

In the disclosure, the term "support member 1810" may be replaced with the term "support plate", "support substrate", "plate", or "substrate".

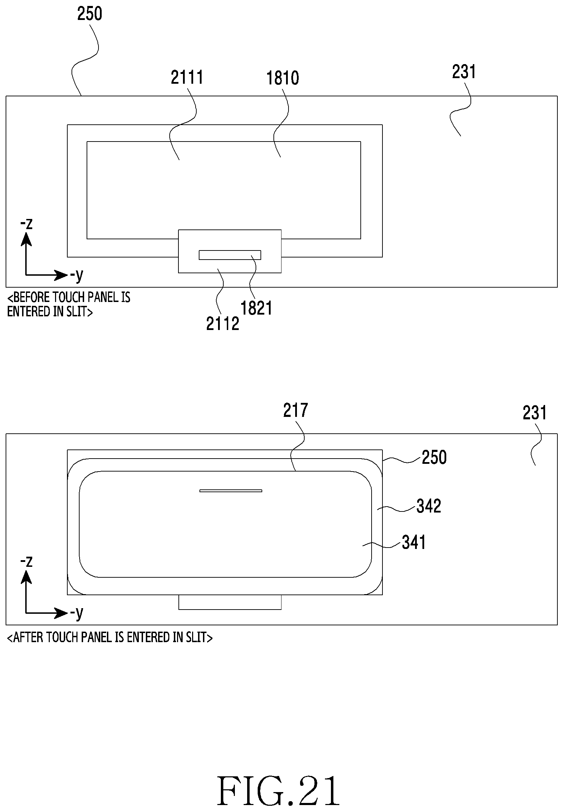

FIG. 21 is a diagram comparing before and after a side key is entered in a groove.

Referring to FIG. 21, the support member 1810 of an embodiment may include a first part 2111 and a second part 2112. For example, the first part 2111 may include a part that contacts a rear face (e.g., the rear face 217b in FIG. 3B) of the side key 217 and supports the side key 217. The second part 2112 may include a part that extends from the first part 2111 and supports the first part 2111. For example, the first part 2111 may include a part that fixes the side key 217 into the groove 250, and the second part 2112 may include a part that supports the first part 2111 wherein the first part 2111 may be coupled with the first side portion 231.

According to an embodiment, a hole 1821 may be formed in the second part 2112. For example, the second part 2112 of the support member 1810 may include the hole 1821 in which the first connection portion 351 of the first conductive connection member 350 is entered.

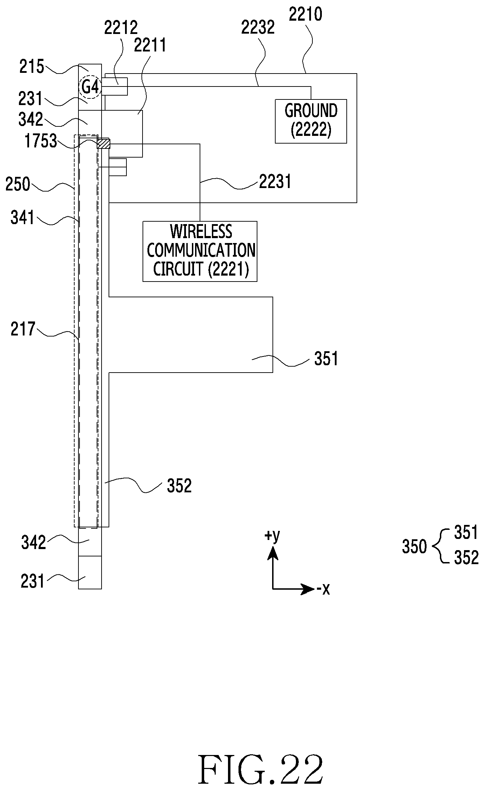

FIG. 22 is a diagram illustrating a wireless communication circuit that feeds power to a conductive portion of a side key through a connection member rather than a first conductive connection member, according to an embodiment.

Referring to FIG. 22, the electronic device 101 of an embodiment may include a connection member 2210, a wireless communication circuit 2221, and/or the ground 2222.

According to an embodiment, the electronic device 101 may include the connection member 2210. For example, the electronic device 101 may include a connection member electrically connected to the side key 217 in addition to the first conductive connection member 350. For example, the connection member may include at least one of an FPCB, a printed circuit board, or an FRC.

According to an embodiment, the connection member 2210 may include a first fill-cut region 2211, a ground connection portion 2212, a first conductive connection path 2231, and/or a second conductive connection path 2232. For example, the first fill-cut region 2211 and the ground connection portion 2212 may include regions where conductive lines formed on the connection member 2210 (e.g., the FPCB) are exposed to the outside. For example, the first fill-cut region 2211 may include a region where the first conductive connection path 2231 is exposed.

According to an embodiment, the wireless communication circuit 2221 may feed power to the conductive portion 341 of the side key 217 through the first fill-cut region 2211. For example, the wireless communication circuit 2221 may feed power to one point of the conductive portion 341 of the side key 217, through the first conductive connection path 2231 exposed in the first fill-cut region 2211 and the connection structure 1753 (e.g., the C-clip). For example, the first conductive connection path 2231 may be exposed in the first fill-cut region 2211, and the first conductive connection path 2231 may be connected to the conductive portion 341 through the connection structure 1753. In this case, the wireless communication circuit 2221 may feed power to the conductive portion 341 through the first conductive connection path 2231 and the connection structure 1753 and transmit and/or receive RF signals in a specified frequency band.

According to an embodiment, the ground 2222 may be electrically connected to a fourth point G4 of the side member 215 through the ground connection portion 2212. For example, the ground 2222 may be electrically connected to the fourth point G4 of the first side portion 231 of the side member 215 through the second conductive connection path 2232 exposed on the ground connection portion 2212.

According to an embodiment, the wireless communication circuit 2221 may be disposed on or in the connection member 2210. For example, the wireless communication circuit 2221 may be arranged at one of a plurality of conductive layers of the connection member 2210.

However, a location at which the wireless communication circuit 2221 is arranged is not limited to the connection member 2210, and the wireless communication circuit 2221 may be arranged at other components (e.g., the first printed circuit board 310) other than the connection member 2210.

According to an embodiment, the ground 2222 may be formed on or in the connection member 2210. For example, the wireless communication circuit 2221 may be formed at at least one of the plurality of conductive layers of the connection member 2210.

However, a location at which the ground 2222 is formed is not limited to the connection member 2210, and the ground 2222 may be formed at various electrical objects (e.g., the first printed circuit board 310) included in the electronic device 101.

According to an embodiment, as the wireless communication circuit 2221 feeds power to the conductive portion 341 of the side key 217, an electrical path may be formed in the first side portion 231 where the conductive portion 341 and the groove 250 are formed. The wireless communication circuit 2221 may transmit and/or receive RF signals, based on the electrical path.

In FIG. 22 of the disclosure, it has been described that the wireless communication circuit 2221 feeds power to the conductive portion 341, but this is only an example. For example, the wireless communication circuit 2221 may feed power to the fourth point G4, and the ground 2222 may be electrically connected to the conductive portion 341.

The wireless communication circuit 2221 of the disclosure may correspond to the wireless communication circuit 321 of FIG. 3.

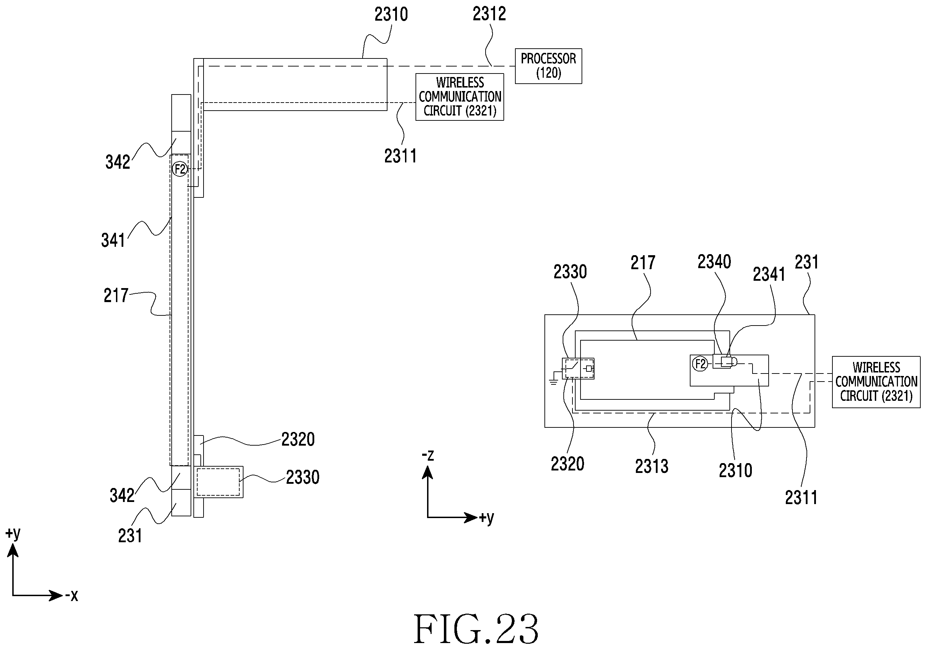

FIG. 23 is a diagram illustrating a first connection member including a first fill-cut region and a second connection member including a second fill-cut region, according to an embodiment.

Referring to FIG. 23, the electronic device 101 of an embodiment may include a first connection member 2310, a second connection member 2320 (e.g., FPCB), a wireless communication circuit 2321, and/or a switch circuit 2330.

According to an embodiment, the first connection member 2310 may include a first conductive connection path 2311 and/or a second conductive connection path 2312. For example, the first conductive connection path 2311 may include an electrical path for the wireless communication circuit 2321 to feed power to a fifth point F2 of the side key 217. In an example, the wireless communication circuit 2321 may feed power to one point (e.g., the fifth point F2) of the conductive portion 341 of the side key 217 through the first conductive connection path 2311.

For example, the second conductive connection path 2312 may include a path for the processor 120 to transmit a signal for controlling the side key 217 to the side key 217.

According to an embodiment, the electronic device 101 may include a third conductive connection path 2313. For example, the third conductive connection path 2313 may include a path for providing connection between the wireless communication circuit 2321 of the side key 217 and the switch circuit 2330. For example, the wireless communication circuit 2321 and/or the processor 120 may transmit a signal for controlling the switch circuit 2330 through the third conductive connection path 2313 to the switch circuit 2330.

According to an embodiment, the switch circuit 2330 may electrically connect or electrically disconnect the conductive portion 341 to or from the first side portion 231. For example, the switch circuit 2330 may electrically connect or electrically disconnect the conductive portion 341 to or from the first side portion 231 under the control of the processor 120 and/or the wireless communication circuit 2321.

In FIG. 23 of the disclosure, it has been described that the switch circuit 2330 provides the connection or disconnection of the adjacent ground (or conductive portions), but this is only an example. For example, the switch circuit 2330 may include at least one lumped element (e.g., an inductor or a capacitor). For example, the switch circuit 2330 may connect or disconnect the conductive portion 341 to the first side portion 231 through the at least one lumped element, thereby adjusting the length of an electrical path (e.g., the electrical path 520 of FIG. 5) that is formed as the wireless communication circuit 2321 feeds power to the fifth point F2. For example, the switch circuit 2330 may connect the conductive portion 341 to the first side portion 231 through a first inductor having a first inductance value. In this case, the electrical length of the antenna 501 may be increased compared to when the first inductor is not connected. For example, the switch circuit 2330 may connect the conductive portion 341 to the first side portion 231 through a first capacitor having a first capacitance value, and in this case, the electrical length of the antenna 501 may be decreased compared to when the first capacitor is not connected.

According to an embodiment, the first connection member 2310 (e.g., the FPCB) may include a fill-cut region 2340, and the first conductive connection path 2311 may be electrically connected to a conductive connection member 2341 (e.g., a C-clip and/or a conductive gasket) in the fill-cut region 2340.

According to an embodiment, the wireless communication circuit 2321 may feed power to the fifth point F2 of the side key 217 through the first conductive connection path 2311 and the conductive connection member 2341.

The switch circuit 2330 of FIG. 23 of the disclosure may correspond to the switch circuit 1420 of FIG. 14, and the description of the switch circuit 1420 of FIG. 14 may be applied to the switch circuit 2330.

The wireless communication circuit 2321 of the disclosure may correspond to the wireless communication circuit 321 of FIG. 3.

According to an embodiment, an electronic device 101 may include a display 201, a rear cover 211, a side member 215 surrounding the space between the display 201 and the rear cover 211, the side member having a groove 250 formed therein, a side key 217 arranged within the groove 250 and including a conductive portion 341, a wireless communication circuit 321, at least one processor 120, and a first conductive connection member 350 electrically connecting the at least one processor 120 to the side key 217. The wireless communication circuit 321 may be configured to feed power to a first portion 510 of the side member 215 surrounding an edge of the groove 250 through the first conductive connection member 350 electrically connecting the at least one processor 120 to the side key 217, and transmit and/or receive RF signals in a specified frequency band, based on an electrical path 520 formed in the first portion 510 of the side member 215 and the conductive portion 341 of the side key 217.

According to an embodiment, the electronic device 101 may further include a first protrusion 420 extending from a portion of the side member adjacent to a first end 250a of the groove 250, in a direction from the first end 250a toward a second end 250b of the groove 250, and a second conductive connection member 353 arranged between the first protrusion 420 and the first conductive connection member 350 of the side key 217. The wireless communication circuit 321 may be configured to feed power to the first portion 510 of the side member 215 through the first conductive connection member 350, the second conductive connection member 353, and the first protrusion 420. The second conductive connection member 353 may include at least one of a C-clip or a conductive gasket.

According to an embodiment, the electronic device 101 may further include a second protrusion 1322 extending from a portion of the side member 215 adjacent to the second end 250b of the groove 250, in a direction from the second end 250b toward the first end 250a, a third conductive connection member 1413 arranged between the second protrusion 1322 and the first conductive connection member 350 of the side key 217, and a switch circuit 1420 electrically connected to the second protrusion 1322 through the first conductive connection member 350 and the third conductive connection member 1413. The third conductive connection member 1413 may include at least one of a C-clip or a conductive gasket.

According to an embodiment, the switch circuit 1420 may be electrically connected to the ground 530 included in a first printed circuit board 310, on which the wireless communication circuit 321 is disposed, and include at least one lumped element. The switch circuit 1420 may be configured to adjust the specified frequency band by changing the length of the electrical path 520 by using the at least one lumped element.

According to an embodiment, the wireless communication circuit 321 may be configured to transmit, to the switch circuit, a control signal for controlling the switch circuit through the first conductive connection member 350.

According to an embodiment, the first conductive connection member 350 may include a first conductive path 371 for feeding power to the first portion 510 and a second conductive path 372 for transmitting a signal transmitted from the side key 217 to the at least one processor 120. The first conductive connection member 350 may include a fill-cut region 353a where the first conductive path 371 is exposed. The first conductive path 371 may be connected to the second conductive connection member 353 in the fill-cut region 353a.

According to an embodiment, the side key 217 may further include a non-conductive portion 342 arranged along an edge of the conductive portion 341. The non-conductive portion 342 may be arranged between the conductive portion 341 of the side key 217 and the first portion 510 of the side member 215.

According to an embodiment, the electronic device 101 may further include a support member 1010 including a conductive material. The support member 1010 may contact a rear face of the side key 217 arranged within the groove 250 and fix the side key 217 into the groove 250.

According to an embodiment, the side member 215 may include a conductive material and form a side face 210c of the electronic device 101 in a seamless loop shape. The first portion 510 of the side member 215 and the side key 217 may form one side face of the electronic device without steps.

According to an embodiment, the electronic device 101 may further include a first printed circuit board 310 on which the wireless communication circuit 321 and the at least one processor 120 are disposed. The at least one processor 120 may be configured to transmit a control signal to the side key 217 through the first conductive connection member 350 electrically connected to the first printed circuit board 310, or receive a signal from the side key 217 through the first conductive connection member 350. The first conductive connection member 350 may include at least one of an FPCB or an FRC. The first conductive connection member 350 may include a first connection portion 351 connected to a connector 312 of the first printed circuit board 310, and a second connection portion 352 connected to the first connection portion 351 of the first conductive connection member 350 and forming a rear face 217b of the side key 217.

According to an embodiment, as the wireless communication circuit 321 feeds power to the first portion 510 of the side member 215, the electrical path 520 may be formed at an edge of the first portion 510 surrounding an edge of the groove 250 and an edge of the conductive portion 341 of the side key 217. The edge of the first portion 510 may be spaced apart from and electromagnetically connected to the edge of the conductive portion 341.

According to an embodiment, the electronic device may further include a non-conductive member formed on an inner surface of the side member 215. The non-conductive member may include an opening 910 at least partially overlapping the groove. The opening 910 may be for allowing the side key 217 to be entered in the groove 250.

According to an embodiment, the opening 910 may include a first region 911 overlapping the groove 250 and a second region 912 extending from the first region and overlapping the side member. The second conductive connection member for connecting the wireless communication circuit 321 to the side member 215 may be electrically connected to the side member 215 through the second region 912.

According to an embodiment, the first conductive connection member 350 may include at least one of an FPCB, a PCB, a portion of a touch panel included in the side key, or an FRC.

According to an embodiment, the side key 217 may include a touch panel. The side key 217 may be configured to identify a user's touch input to the touch panel or identify a pressure applied to the touch panel, and transmit a signal indicating the presence of the user's input, based on the touch input or the pressure, to the at least one processor.

According to an embodiment, an electronic device 101 may include a side member 215 having a groove 250 formed therein and forming a side face of the electronic device 101, a side key 217 arranged within the groove 250 and including a conductive portion, a wireless communication circuit 321, at least one processor, and a first conductive connection member electrically connecting the at least one processor to the side key. The wireless communication circuit 321 may be configured to feed power to a first portion of the side member surrounding an edge of the groove through the first conductive connection member electrically connecting the at least one processor to the side key 217, and transmit and/or receive RF signals in a specified frequency band, based on an electrical path that is formed in the first portion of the side member and the conductive portion of the side key.

According to an embodiment, the electronic device 101 may further include a first protrusion extending from a portion of the side member adj acent to a first end of the groove, in a direction from the first end toward a second end of the groove, and a second conductive connection member arranged between the first protrusion and the first conductive connection member of the side key. The wireless communication circuit 321 may be configured to feed power to the first portion of the side member through the first conductive connection member, the second conductive connection member, and the first protrusion. The second conductive connection member may include at least one of a C-clip or a conductive gasket.

According to an embodiment, the electronic device may further include a second protrusion extending from a portion of the side member adjacent to the second end of the groove 250, in a direction from the second end toward the first end, a third conductive connection member arranged between the second protrusion and the first conductive connection member of the side key, and a switch circuit electrically connected to the second protrusion through the first conductive connection member and the third conductive connection member. The third conductive connection member may include at least one of a C-clip or a conductive gasket.

According to an embodiment, the switch circuit may be electrically connected to the ground included in a printed circuit board on which the wireless communication circuit is disposed, and include at least one lumped element. The switch circuit may be configured to adjust the specified frequency band by changing the length of the electrical path by using the at least one lumped element.

According to an embodiment, the wireless communication circuit 321 may be configured to transmit a control signal for controlling the switch circuit through the first conductive connection member.

## Claims

1. An electronic device comprising:
a display;
a rear cover;
a side member surrounding a space between the display and the rear cover, wherein the side member comprises a groove;
a side key disposed in the groove and comprising a conductive portion;
a wireless communication circuit;
at least one processor; and
a first conductive connection member electrically connecting the at least one processor to the side key,
wherein the wireless communication circuit is configured to:
feed power to a first portion of the side member surrounding an edge of the groove through the first conductive connection member electrically connecting the at least one processor to the side key; and
transmit and/or receive radio frequency (RF) signals in a specific frequency band, based on an electrical path formed in the first portion and the conductive portion.

2. The electronic device of claim 1, further comprising:
a first protrusion extending from a portion of the side member adjacent to a first end of the groove, wherein the first protrusion extends in a direction from the first end toward a second end of the groove; and
a second conductive connection member disposed between the first protrusion and the first conductive connection member,
wherein the wireless communication circuit is further configured to feed power to the first portion through the first conductive connection member, the second conductive connection member, and the first protrusion, and
wherein the second conductive connection member comprises at least one of a C-clip or a conductive gasket.

3. The electronic device of claim 2, further comprising:
a second protrusion extending from a portion of the side member adjacent to the second end of the groove, wherein the second protrusion extends in a direction from the second end toward the first end;
a third conductive connection member disposed between the second protrusion and the first conductive connection member; and
a switch circuit electrically connected to the second protrusion through the first conductive connection member and the third conductive connection member,
wherein the third conductive connection member comprises at least one of a C-clip or a conductive gasket.

4. The electronic device of claim 3, further comprising:
a printed circuit board comprising the wireless communication circuit and a ground,
wherein the switch circuit is electrically connected to the ground and comprises at least one lumped element, and
wherein the switch circuit is configured to adjust the specific frequency band by changing a length of the electrical path using the at least one lumped element.

5. The electronic device of claim 3, wherein the wireless communication circuit is further configured to transmit a control signal for controlling the switch circuit through the first conductive connection member.

6. The electronic device of claim 2,
wherein the first conductive connection member comprises:
a first conductive path for feeding power to the first portion;
a second conductive path for transmitting a signal from the side key; and
a region in which the first conductive path is exposed, and
wherein the first conductive path is connected to the second conductive connection member in the region.

7. The electronic device of claim 1,
wherein the side key further comprises a non-conductive portion disposed along an edge of the conductive portion, and
wherein the non-conductive portion is disposed between the conductive portion of the side key and the first portion of the side member.

8. The electronic device of claim 1, further comprising a support member comprising a conductive material,
wherein the support member contacts a rear face of the side key, and fixes the side key into the groove.

9. The electronic device of claim 1,
wherein the side member comprises a conductive material and forms at least a portion of a side face of the electronic device in a seamless loop shape, and
wherein the first portion and the side key form a portion of the side face of the electronic device without steps.

10. The electronic device of claim 1, further comprising a printed circuit board on which the wireless communication circuit and the at least one processor are disposed,
wherein the first conductive connection member comprises a first portion connected to a connector of the printed circuit board, and a second portion forming a rear face of the side key, and
wherein the at least one processor is configured to transmit a control signal to the side key through the first conductive connection member, or to receive a signal from the side key through the first conductive connection member.

11. The electronic device of claim 1,
wherein the electrical path is formed at an edge of the first portion and an edge of the conductive portion, and
wherein the edge of the first portion is spaced apart from and electromagnetically connected to the edge of the conductive portion.

12. The electronic device of claim 1, further comprising a non-conductive member formed on an inner surface of the side member,
wherein the non-conductive member comprises an opening at least partially overlapping the groove, and
wherein the opening is for the side key to be entered in the groove.

13. The electronic device of claim 12,
wherein the opening comprises a first region overlapping the groove and a second region extending from the first region and overlapping the side member, and
wherein the second conductive connection member is electrically connected to the side member through the second region.

14. The electronic device of claim 1, wherein the first conductive connection member comprises at least one of a flexible printed circuit board (FPCB), a printed circuit board, a portion of a touch panel comprised in the side key, or a flexible RF cable (FRC).

15. The electronic device of claim 1,
wherein the side key comprises a touch panel, and
wherein the side key is configured to:
identify a touch input of a user to the touch panel based on a pressure applied to the touch panel, and
transmit, to the at least one processor, a signal indicating identification of touch input of the user.
